# EUROPEAN PATENT SPECIFICATION

(11) **EP 1 892 741 B1**
(45) Date of publication and mention of the grant of the patent: **28.09.2011**
(21) Application number: 06766923.4
(22) Date of filing: 19.06.2006
(51) Int. Cl.: H01J 1/15, H01J 37/06, H01J 37/305

(54) **DIAMOND ELECTRON EMISSION CATHODE, ELECTRON EMISSION SOURCE, ELECTRON MICROSCOPE, AND ELECTRON BEAM EXPOSURE DEVICE**
DIAMANTENELEKTRONEN-EMISSIONSKATHODE, ELEKTRONENEMISSIONSQUELLE, ELEKTRONENMIKROSKOP UND ELEKTRONENSTRAHLBELICHTUNGSVORRICHTUNG
CATHODE D'EMISSION D'ELECTRONS EN DIAMANT, SOURCE D'EMISSION D'ELECTRONS, MICROSCOPE ELECTRONIQUE ET DISPOSITIF D'EXPOSITION À FAISCEAU ELECTRONIQUE

(30) Priority: 17.06.2005 JP 2005178163; 06.09.2005 JP 2005257452; 06.09.2005 JP 2005257791
(43) Date of publication of application: 27.02.2008
(73) Proprietor: Sumitomo Electric Industries, Ltd., Osaka-shi, Osaka 541-0041 (JP)
(72) Inventor: Nishibayashi, Yoshiki, Hyogo 6640016 (JP); Ueda, Akihiko, Hyogo 6640016 (JP); Yamamoto, Yoshiyuki, Hyogo 6640016 (JP); Imai, Takahiro, Hyogo 6640016 (JP)
(74) Representative: Cross, Rupert Edward Blount
(86) International application number: PCT/JP2006/312261
(87) International publication number: WO 2006/135092

(56) References cited:
- EP-A1- 1 536 043
- WO-A1-2005/034164
- JP-A- 06 036 680
- JP-A- 07 094 077
- JP-A- 09 199 001
- JP-A- 10 312 735
- JP-A- 62 140 332
- JP-A- 2004 119 018
- JP-A- 2004 119 019
- JP-A- 2005 108 634
- JP-A- 2005 108 637
- US-A1- 2005 042 743
- ANDO Y ET AL: "Smooth and high-rate reactive ion etching of diamond" DIAMOND AND RELATED MATERIALS, ELSEVIER SCIENCE PUBLISHERS, AMSTERDAM, NL LNKD- DOI:10.1016/S0925-9635(01)00617-3, vol. 11, no. 3-6, 1 March 2002 (2002-03-01), pages 824-827, XP004357027 ISSN: 0925-9635
- ANDO Y ET AL: "Spiky diamond field emitters" DIAMOND AND RELATED MATERIALS, ELSEVIER SCIENCE PUBLISHERS, AMSTERDAM, NL LNKD- DOI:10.1016/S0925-9635(03)00257-7, vol. 12, no. 10-11, 1 October 2003 (2003-10-01), pages 1681-1684, XP004479841 ISSN: 0925-9635
- ANDO Y ET AL: "'Nano-rods' of single crystalline diamond" DIAMOND AND RELATED MATERIALS, ELSEVIER SCIENCE PUBLISHERS, AMSTERDAM, NL LNKD- DOI:10.1016/J.DIAMOND.2003.10.066, vol. 13, no. 4-8, 1 April 2004 (2004-04-01), pages 633-637, XP004507835 ISSN: 0925-9635
- NANBA A. ET AL.: 'Rin dope Diamond Handotai no Sakusei to Denshi Emitter eno Oyo' SEI TECHNICAL REVIEW, SUMITOMO ELECTRIC INDUSTRIES, LTD. vol. 166, March 2005, pages 38 - 44, XP003006925

## Description

### TECHNICAL FIELD

The present invention relates to a diamond electron emission cathode and an electron emission source for use in electron beams and electron beam devices such as electron microscopes and electron beam exposure devices and in vacuum tubes such as traveling wave tubes and microwave tubes, and also relates to an electronic device using such cathode and source.

### BACKGROUND ART

Because an electron bears a negative charge and has a very small mass, electron beams in which electrons are arranged to travel in one direction have the following special features. (1) The direction and the degree of convergence can be controlled by an electric or magnetic field. (2) Energy in a wide range can be obtained by acceleration and deceleration with an electric field. (3) Because the wavelength is short, the beam can be converged to a small diameter. Electron microscopes and electron beam exposure devices employing such special features have been widely used. As cathode materials for such devices, cheap W filaments or hexaborides, e.g., LaB₆ which can produce an electron beam with a high brightness, are exemplified for thermal electron emission sources. Further, W with a sharpened tip that uses a tunnel phenomenon based on a quantum effect and ZrO/W using the Schottky effect based on electric filed application have been used as cathodes with a high brightness and a narrow energy width.

However, although W filaments are inexpensive, a problem associated therewith is that the service life thereof is extremely short (about 100 h). As a result, a replacement operation such as opening a vacuum container to the atmosphere or adjusting the optical axis of electron beam when the filament is broken has to be frequently performed. The service life of LaB₆ is about 1000 h and longer than that of W filaments, but because it is used in devices in which beams with a comparatively high brightness are obtained, the replacement operation is most often performed by the device manufacturers and the cost thereof is high. A problem associated with ZrO/W that has a comparatively long service life of about one year and W with a sharpened tip that allows a higher brightness to be obtained is that the replacement cost is high.

Because electron microscopes are presently required to enable highly accurate observations of even smaller objects and because electron beam exposure devices have been advanced to a node size of less than 65 nm, the cathodes with even higher brightness and narrower energy width are needed.

Diamond is a material that meets such expectations. Diamond exists in a state with a negative electron affinity (NEA) or in a state with a positive electron affinity (PEA) less than that of metals with a small work function, as described in Non-Patent Document 1 and Non-Patent Document 2. By employing such an extremely unique physical property, it is possible to obtain electron emission with a high current density and to reduce the energy width, without requiring a high temperature in excess of 1000°C as in W filaments, LaB₆, or ZrO/W. Further, because the operation temperature is low, a long service life can be expected. In addition, because there is a microprocessing technology allowing a tip end diameter of 10 nm to be obtained, as described in Non-Patent Document 3, no problems are associated with increase in brightness. Since diamond has been found to have the aforementioned electron affinity, electron sources as described in Non-Patent Document 4 and Patent Document 1 have been proposed.

Non-Patent Document 1: F. J. Himpsel et al., Phys. Rev. B, Vol. 20, Number 2 (1979), 624-;
Non-Patent Document 2: J. Ristein et al., New Diamond and Frontier Carbon Technology, Vol. 10, No. 6, (2000) 363-;
Non-Patent Document 3: Y. Nishibayashi et al., SEI Technical Review, 57, (2004) 31-;
Non-Patent Document 4: W. B. Choi et al., J. Vac. Sci. Technol. B14 (1996) 2051-; and
Patent Document 1: Japanese Patent Publication No. 4-67527A

### DISCLOSURE OF THE INVENTION

### PROBLEMS THAT THE INVENTION IS TO SOLVE

However, the following problems are encountered when electron sources using diamond are employed in electronic microscopes or electron beam exposure devices that have become widely spread. Thus, structures in which a plurality of electron emission points, such as described in Non-Patent Document 3, are arranged side by side become plane electron sources and a small-diameter beam is difficult to obtain by converging. Mounting on the device is also a difficult task. No problems are associated with shape when Mo with a sharp tip is coated with diamond, as described in Non-Patent Document 4, but because of a polycrystalline structure there are differences among individual species and variations in electric characteristics. Because the structure suggested in Patent Document 1 is also a plane electron source, a converged beam is difficult to obtain. Such source is also difficult to mount on the device.

Accordingly, with the foregoing in view, it is an object of the present invention to provide an electron emission cathode and an electron emission source using diamond and having a high brightness and a small energy width that are suitable for electron ray and electron beam devices and vacuum tubes, in particular, electron microscopes and electron beam exposure devices, and to an electron microscope and an electron beam exposure device that use such electron emission cathode and electron emission source.

### MEANS FOR SOLVING THE PROBLEMS

In order to resolve the above-described problems, the diamond electron emission cathode in accordance with the present invention adopts the configuration as defined in the appended claim 1.
(1) A diamond electron emission cathode in accordance with the present invention consisting of single crystal diamond, wherein the diamond electron emission cathode is in a columnar form comprising a sharpened acute section having one electron emitting portion as an apex therein and is constituted by at least two types of semiconductors that differ in electric properties, one of the types constituting the semiconductors is an n-type semiconductor comprising n-type impurities at 2 × 10¹⁵ cm⁻³ or higher, the other type is a p-type semiconductor comprising p-type impurities at 2 × 10¹⁵ cm⁻³ or higher, the p-type semiconductor and the n-type semiconductor are joined directly or indirectly via a layer of another type (for example, an intrinsic semiconductor layer) in the sharpened each section. An electric potential that is negative with respect to the p-type semiconductor is applied with a pair of current introducing terminals to the n-type semiconductor so that electrons flow from the n-type semiconductor to the p-type semiconductor, a joining interface of the p-type semiconductor and n-type semiconductor is positioned close to the electron emitting portion, and the n-type semiconductor has a component in which electrons flow to the emitting portion.

Such diamond electron emission cathode contains almost no dissimilar materials. Therefore, cathode fracture during heating and cooling caused by the difference in thermal expansion coefficients is prevented. The term "almost" used herein indicates the case where the cathode shape of the diamond electron emission cathode does not depend on any material other than diamond. Accordingly, this excludes the case where the cathode shape, except the below-described heating section, mainly depends on a material other than diamond, as in the shape in which diamond is coated on Mo having a sharp tip, as described in Non-Patent Document 4. Further, because at least part of the diamond electron emission cathode is composed of single crystal diamond, the doping concentration of n-type impurities that are necessary to use diamond as a cathode material can be controlled in the process of vapor-phase growing the diamond, this control being difficult with the polycrystalline materials.

The diamond electron emission cathode in accordance with the present invention contains n-type impurities at 2 × 10¹⁵ cm⁻³ or higher. This value indicates the value obtained in the vicinity of the electron emitting portion. When n-type impurities are contained at such concentration, electrons are supplied into the conduction band of the diamond. Therefore, the work function is substantially small and electron emission is possible at a high current density.
Further, the diamond electron emission cathode in accordance with the present invention preferably has a structure having an electrically conductive layer or semiconductor layer containing n-type impurities at 2 × 10¹⁵ cm⁻³ or higher in at least a portion on the diamond containing p-type impurities at 2 × 10¹⁵ cm⁻³ or higher. In the diamond, the level of p-type impurities is shallow and a low resistance can be obtained. Therefore, in this case, a lower resistance value of the entire cathode can be obtained.

By making the entire diamond electron emission cathode in a columnar form with one sharpened acute section having an electron emitting portion, the drop of voltage at the cathode is decreased, whereby the electron emission efficiency can be increased. As a result, an electron emission cathode and an electron emission source using diamond and having a narrow energy width and a high brightness can be realized.

(2) In the diamond electron emission cathode in accordance with the present invention, one type constituting the diamond semiconductors is preferably an intrinsic semiconductor constituted by diamond with a carrier concentration of 1 × 10⁹ cm⁻² or less at 300 K. By forming an intrinsic semiconductor layer, electrons can be emitted more effectively.
(3) It is preferred that the diamond electron emission cathode in accordance with the present invention have a heating section formed therein. By forming a heating section in the diamond electron emission cathode in accordance with the present invention, the removal of moisture or the like that has adhered to the surface of the electron emitting portion necessary for stabilizing the emission current can be performed in an easy manner by heating via the heating section.
(4) In the diamond electron emission cathode in accordance with the present invention, the electron emitting portion is preferably formed by the n-type semiconductor. With the n-type semiconductor, the amount of electrons in the electron flow can be increased and the electron emission characteristic is improved.

(5) In the diamond electron emission cathode in accordance with the present invention, the electron emitting portion is preferably formed by the p-type semiconductor. The p-type semiconductor has a low work function and the electrons flow with good efficiency. Therefore, a good electron emission characteristic can be obtained.
(6) In the diamond electron emission cathode in accordance with the present invention, the electron emitting portion is preferably formed by the intrinsic semiconductor.
(7) In the diamond electron emission cathode in accordance with the present invention, it is preferred that the p-type semiconductor comprise a bulk crystal synthesized by vapor phase growth, and the n-type semiconductor and/or the above-mentioned intrinsic semiconductor comprise a thin-film crystal synthesized by vapor phase growth. By synthesizing a diamond semiconductor by vapor phase growth, the introduction of impurities is reduced and a high-quality bulk crystal is obtained, whereby the electron emission efficiency is increased.

(8) In the diamond electron emission cathode in accordance with the present invention, the length in the short side direction of the diamond electron emission cathode is preferably 0.05 mm or more to 2 mm or less and the aspect ratio thereof is preferably 1 or more. Such a shape allows the diamond electron emission cathode to be easily mounted on electron beam devices such as electron microscopes and electron beam exposure devices.
The "length in the short side direction" as referred to herein indicates a total width of the bottom section on the side opposite to the electron emitting portion of the diamond electron emission cathode. When the diamond electron emission cathode is a rectangular parallelepiped, this direction indicates a short side of the width of the bottom section. The "aspect ratio" as referred to herein is a ratio of the length in the longitudinal direction to that in the short side direction, where the length from the tip end of the electron emitting portion to the bottom section on the opposite side is taken as the longitudinal direction.

(9) In the diamond electron emission cathode in accordance with the present invention, at least one plane of the planes which form the electron emitting portion as a tip apex in the sharpened acute section is preferably formed by a (111) crystal plane [including off-planes within ±7° from the (111) just plane].
The stable growth plane in the vapor phase growth is a (100) plane or (111) plane, but the n-type impurity intake efficiency of the (111) plane in the vapor phase growth process is 10 or more times that of the (100) plane. It means that the (111) crystal plane of diamond enables high-concentration doping with n-type impurities, a metallic conduction can be easily obtained, and electron emission at a high current density can be obtained. Therefore, in the case where the electron emitting portion has a (111) crystal plane, a high-brightness electron emission cathode can be easily obtained.

(10) In the diamond electron emission cathode in accordance with the present invention, a surface of the diamond constituting the electron emitting portion is preferably terminated with hydrogen atoms.
By terminating a surface of the diamond constituting the electron emitting portion with hydrogen atoms, the electron affinity is reduced and the efficiency of electron emission characteristic can be increased. Terminating 50% or more of the dangling bonds of the surface carbon of diamond with hydrogen atoms is especially effective.

(11) In the diamond electron emission cathode in accordance with the present invention, a specific resistance of the n-type semiconductor at 300 K is preferably 300 Ωcm or less.
With the diamond electron emission cathode of such a resistivity, electrons are efficiently supplied to the portion containing n-type impurities. As a result, high-density electron emission is possible and a high-brightness electron emission cathode is obtained. It is especially preferred that a specific resistance in the vicinity of the electron emitting portion be within the above-descried range.

(12) In the diamond electron emission cathode in accordance with the present invention, a tip end curvature radius of the sharpened acute section is preferably 30 µm or less.
By making the tip end portion, which forms the electron emitting portion, in such a small size, an electron emission cathode with a higher brightness can be obtained.

(13) In the diamond electron emission cathode in accordance with the present invention, it is preferred that the electron emitting portion have a protruding structure, a tip end diameter of the protrusion be 5 µm or less, and an aspect ratio thereof be 2 or more.
When only the electron emitting portion of the entire diamond single crystal serving as an electron emission cathode has such a sharpened acute shape, it is possible to realize a high-brightness diamond thermal field emission cathode or diamond field-emission cathode that can be easily mounted on an electron microscope or electron beam exposure device.

In the diamond electron emission cathode in accordance with the present invention, a temperature during electron emission is preferably 400 K or more to 1200 K or less. With the temperature during electron emission below 400 K, a sufficient emission current cannot be obtained and if the temperature exceeds 1200 K, a long serving life cannot be obtained. It is even more preferred that the temperature during electron emission be 400 K or more or 900 K or less.
(14) In the diamond electron emission cathode in accordance with the present invention, an electron beam with an energy width of 0.6 eV or less is preferably emitted from the electron emitting portion. A diamond electron emission cathode with a good electron beam can be provided.

(15) In the diamond electron emission cathode in accordance with the present invention, the heating section preferably has a metal layer. Because the presence of a metal layer decreases electric resistance, the source voltage used for heating can be decreased and the diamond electron emission cathode is suitable for mounting on electron beam devices such as electron microscopes and electron beam exposure devices.
(16) In the diamond electron emission cathode in accordance with the present invention, it is preferred that the surface of the diamond electron emission cathode be covered with a metal layer and the shortest distance from the electron emitting portion to an end section of the metal layer be 500 µm or less. If the distance of 500 µm is exceeded, the electron emission characteristic is degraded. Furthermore, the distance from the electron emitting portion is preferably 100 µm or less.

(17) A diamond electron emission source in accordance with the present invention is a structure for mounting the diamond electron emission cathode in accordance with the present invention on an electron microscope or electron beam exposure device, this structure comprising the diamond electron emission cathode in accordance with the present invention, an insulating ceramic, and a pair of terminals for supplying an electric current to the diamond electron emission cathode, wherein a resistance value between the terminals is preferably 10 Ω or more to 3 kΩ or less. In this case, the diamond electron emission cathode in accordance with the present invention can be mounted without special modifications on the power source system of electron beam devices where the conventional cathode material has been used.

(18) A diamond electron emission source in accordance with the present invention is a structure comprising the diamond electron emission cathode in accordance with the present invention, an insulating ceramic, and a pair of terminals for supplying an electric current to the diamond electron emission cathode, wherein a resistance value between the terminals is preferably 10 Ω or more to 700 Ω or less.
(19) A diamond electron emission source in accordance with the present invention is a structure for mounting the diamond electron emission cathode in accordance with the present invention on an electron microscope or electron beam exposure device, this structure comprising the diamond electron emission cathode in accordance with the present invention, an insulating ceramic and a pair of supporting terminals that clamp an insulating ceramic, fix it to the insulating ceramic and supply an electric current to the diamond electron emission cathode, wherein the supporting terminals are brought into direct contact with the diamond electron emission cathode.

In such diamond electron emission source, the diamond electron emission cathode, which is a novel cathode material, can be easily installed in the electron beam devices that have been using W filaments, LaB₆, or sharpened W, ZrO/W, which are the conventional cathode materials. Moreover, due to the structure in which the supporting terminals directly clamp the diamond electron emission cathode, the optical axes can be easily aligned during fabrication of the diamond electron emission source and the possibility of displacement or separation during use is very low.
(20) The pair of terminals or the pair of supporting terminals in the diamond electron emission source in accordance with the present invention preferably have a melting point of 1700 K or less. Because electron emission from diamond is possible at a temperature lower than that of W filaments, LaB₆, or ZrO/W, a metal with a low melting point can be used and an electron emission source can be constructed by using a low-cost metal material.

(21) An electron microscope in accordance with the present invention has installed therein the diamond electron emission cathode or diamond electron emission source in accordance with the present invention. Because the diamond electron emission cathode or diamond electron emission source in accordance with the present invention makes it possible to obtain an electron beam with a high current density, high brightness, and low energy width, observations can be performed at a magnification ratio higher than that in the electron microscopes using the conventional cathode materials.

(22) An electron beam exposure device in accordance with the present invention has installed therein the diamond electron emission cathode or diamond electron emission source in accordance with the present invention. Because the diamond electron emission cathode or diamond electron emission source in accordance with the present invention makes it possible to obtain an electron beam with a high current density, high brightness, and low energy width, the device of the present invention makes it possible to draw a fine pattern at a higher throughput than in the electron beam exposure devices using the conventional cathode material.

### EFFECTS OF THE INVENTION

With the present invention, it is possible to realize an electron emission cathode and electron emission source that use diamond and have a high brightness and a small energy width and suitable for electron beam and electron beam devices and vacuum tubes, in particular electron microscopes and electron beam exposure devices. Furthermore, by using the electron emission cathode and electron emission source, it is possible to realize an electron microscope enabling high-magnification observations and an electron beam exposure device in which fine patterns can be drawn at a high throughput.

### BEST MODE FOR CARRYING OUT THE INVENTION

The preferred modes for carrying out the diamond electron emission cathode, electron emission source, electron microscope, and electron beam exposure device in accordance with the present invention will be described hereinbelow in greater detail with reference to the appended drawings. In the explanation of the drawings, identical elements will be assigned with identical reference symbols and the redundant explanation will be omitted. The dimensional ratio in the drawings does not necessarily match that in the description.

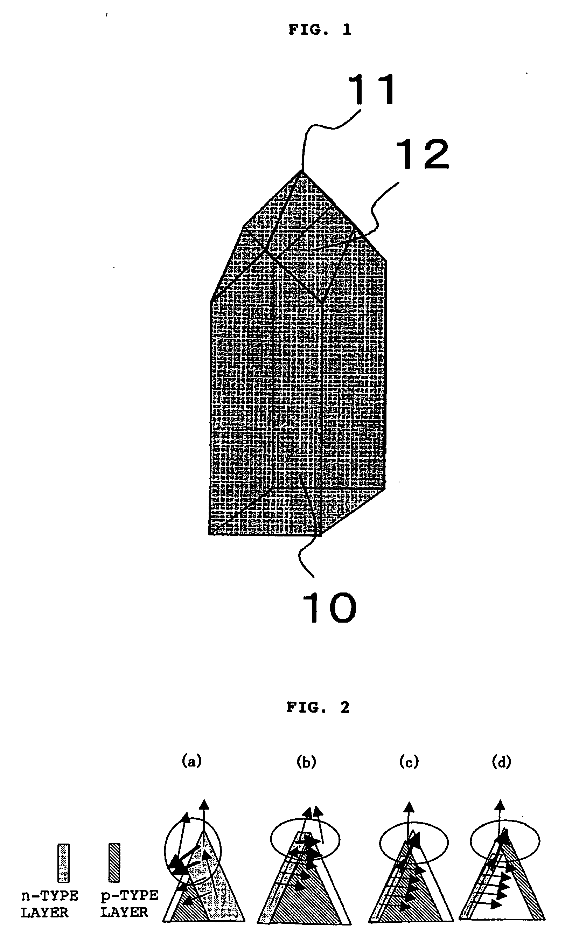

FIG. 1 is a three-dimensional view illustrating an implementation mode of the diamond electron emission cathode in accordance with the present invention. The diamond electron emission cathode comprises a diamond 10 and a diamond electrically conductive layer 12 on the sharpened acute section. A single crystal diamond is used as the diamond 10. A natural single crystal or a single crystal artificially synthesized by a high-temperature high-pressure synthesis method or vapor phase synthesis method may be used for the diamond 10. It is preferred that diamond comprising p-type impurities at 2 × 10¹⁵ cm⁻³ or higher be used. Alternatively, an intrinsic semiconductor with a carrier concentration of 10⁹ cm⁻³ or less is also preferred, provided that a p-type layer, an n-type layer, and a metal are formed into an appropriately configured arrangement. Because the activation energy of p-type impurities in the diamond is low, a low resistance is obtained. Therefore, in this case, the resistance value of the entire cathode becomes even lower. As a result, voltage drop on the cathode is reduced, thereby increasing the electron emission efficiency. A B-doped single crystal diamond of Ib type obtained by high-temperature high-pressure synthesis and a B-doped single crystal diamond obtained by vapor phase synthesis can be advantageously used. A diamond electrically conductive layer 12 is formed with a sharpened electron emitting portion 11 on the surface of the diamond 10 as an apex.

The formation of the diamond electrically conductive layer 12 is preferably performed by epitaxial growth based on a vapor phase synthesis method in order to reduce spread or individual difference in electric conduction characteristic between the diamonds that produce a large effect on electron emission characteristic. The growth is preferably performed by a plasma CVD method that uses microwaves and can control impurity concentration with high accuracy. In the diamond electrically conductive layer 12, n-type impurities are contained at 2 × 10¹⁵ cm⁻³ or higher, electrons are supplied to the conduction band of diamond, and electron emission can be conducted at a high current density. As a result, an electron emission cathode with a high brightness is obtained. In order to obtain an electron emission cathode with even higher brightness, the concentration of n-type impurities is preferably 2 × 10¹⁹ cm⁻³ or higher. When the impurities are contained at such a high concentration, the distance between the donors in the diamond crystal becomes extremely small, and the electric conduction mechanism starts making a transition from the semiconductor conduction to metal conduction in the diamond electrically conductive layer 12.

Because the room-temperature resistance starts to decrease abruptly, the voltage drop at the diamond electron emission cathode itself during electron emission decreases. Therefore, electron emission with a higher current density becomes possible and a high-brightness electron emission cathode is obtained. At this time, for example, P or S is used as the n-type doping element. For example, H₂ or CH₄ is used as a starting material gas employed for vapor phase deposition, and PH₃ or H₂S is used as a doping gas. The synthesis can be performed under the following conditions. Thus, in the case of P doping, the numerical ratio of C atoms and H atoms in the vapor phase is C/H = 0.005-10% and the numerical ratio of P atoms and C atoms is P/C = 10⁻⁴-100%. In the case of S doping, C/H = 0.005-10% and the numerical ratio of S atoms and C atoms is S/C = 10⁻²-100%. The temperature conditions are 600-1300°C for both P and S doping. The diamond 10 is in a columnar form with a length in the short side direction of 0.05 mm or more to 2 mm or less and an aspect ratio of 1 or more, so that the electron emission cathode can be installed in an electron gun chamber produced as an electron extraction structure of an electron microscope or electron beam exposure device.

FIG. 2 is a cross-sectional view illustrating a structure in which a p-type semiconductor and an n-type semiconductor in the diamond electron emission cathode in accordance with the present invention are joined in the sharpened acute section. This cross-sectional view represents a cross-sectional shape parallel to the conduction direction along the electron emitting portion.
With such a structure, it is important that a voltage be applied so as to move electrons from the n-type layer toward the p-type layer and that the electrons move in this direction.
In FIGS. 2(a), (b), the distalmost tip end portion is the n-type layer, and usually depletion occurs in the interface of the tip end portion of the n-type layer and the p-type layer and the conduction band is in a state almost free from electrons. Therefore, under such conditions, a state is assumed in which electrons are difficult to be extracted. However, if an external accelerating voltage or extraction voltage for electron extraction is applied and the chip voltage is applied to the pn-junction in the forward direction, then depletion at the interface with the tip end portion is eliminated and the vicinity thereof is filled with electrons. Although the electrons flow in the p-type direction, electrons are supplied in the direction of compensating the loss thereof. This direction matches the direction of electron extraction into vacuum and the electrons can be easily supplied even into the emission point. Thus, a pn junction is present in the vicinity of the tip end portion, and if a chip voltage is applied in the forward direction, the electrons are circulated so that they can be easily extracted into vacuum. This is the reason why "the n-type semiconductor has a component which transports the electrons into the electron emitting portion" is effective.
In FIGS. 2(c), (d), the distalmost tip end portion is of the p type. Usually depletion occurs in the vicinity of the tip end portion of the p-type layer or pn junction interface, and a state is assumed in which neither electrons, nor holes are present in the conduction band. Therefore, under such conditions, the electrons are difficult to extract into vacuum. However, if an external accelerating voltage or extraction voltage for electron extraction is applied and a voltage is applied to the pn-junction in the forward direction, then the depletion at the interface is eliminated and electrons flow into the p-type layer. However, the depletion gradually proceeds in the distalmost tip end portion. The depletion in the p-type layer is the formation of space in which the electrons can move without colliding with holes and it acts in the direction of pulling the electrons to the distalmost tip end. Therefore, almost all electrons injected into the p-type layer pass through the p-type layer and then through the depletion layer and concentrate in the tip end, thereby assuming a state in which they can be extracted into vacuum. This is the reason why "the p-type semiconductor has a component which transports the electrons into the electron emitting portion" is effective.
In both case, a chip voltage in the forward direction and a sharpened tip end are important. No such phenomenon occurs with the flat tip end.

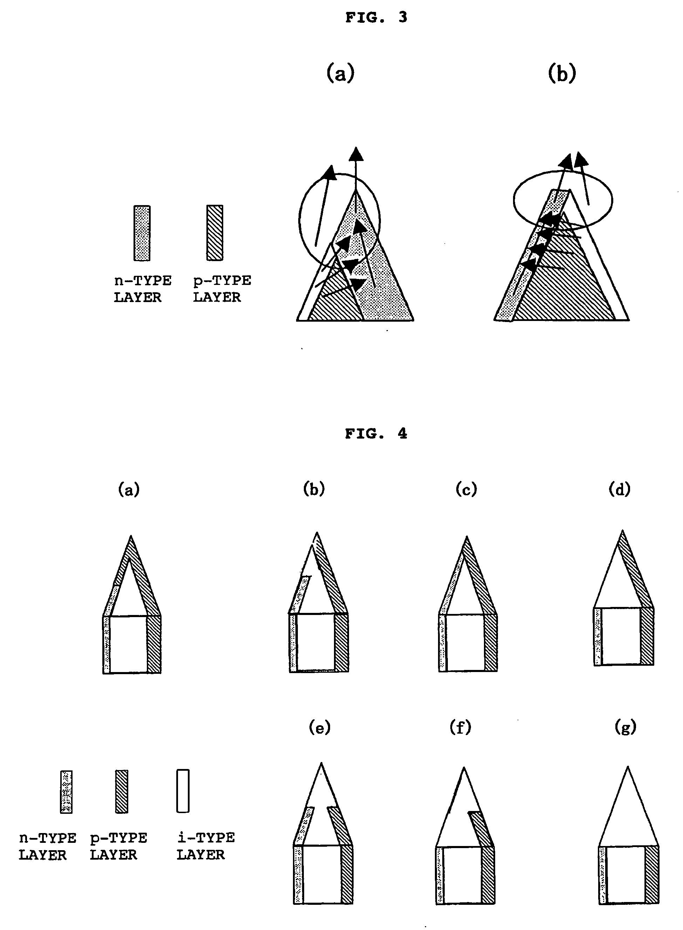

FIG. 3 is a cross-sectional view illustrating another structure in which a p-type semiconductor and an n-type semiconductor in the diamond electron emission cathode in accordance with the present invention are joined in the sharpened acute section.
FIGS. 3(a) and (b) show one sharpened acute section having an electron emitting portion and illustrate a diamond electron emission cathode composed of two types of diamond semiconductors with different electric properties. One of the two types constituting the diamond semiconductors is a p-type layer comprising p-type impurities at 2 × 10¹⁵ cm⁻³ or higher and the other type of semiconductor is an n-type semiconductor comprising n-type impurities at 2 × 10¹⁵ cm⁻³ or higher. A potential positive with respect to the p-type layer is applied to the n-type layer so as to create a direction of electron flow from the p-type layer to the n-type layer. Furthermore, the p-type layer has a component in which electrons move toward the electron emitting portion. In the configuration shown in FIGS. 3(a) and (b), the electron emitting portion is an n-type layer and employing such a configuration makes it possible to realize an electron emission cathode and electron emission source of high brightness and small energy width.

FIG. 4 is a cross-sectional view illustrating a structure in which in which a p-type semiconductor and an n-type semiconductor in the diamond electron emission cathode in accordance with the present invention are joined in the sharpened acute section and which has an intrinsic semiconductor.
Even when an intrinsic semiconductor layer (also referred to hereinbelow as "i-type layer") that is composed of an intrinsic semiconductor is present in the center, the explanation can be the same as related to FIG. 2. The advantage of the configuration in which the i-type layer takes a large volume is that electrons can travel easily. It is suffice if the p-type layer facing and joining to the n-type layer via the i-type layer has a thickness ensuring a potential for extracting electrons. However, it is important to note that if the p-type layer is too thin, then depletion occurs in the entire layer and a potential that draws electrons cannot be ensured.
FIGS. 4(a)-(d) show one sharpened acute section having an electron emitting portion and illustrate a diamond electron emission cathode composed of diamond semiconductors of two types with different electric properties. One of the types constituting the diamond semiconductors is a p-type layer comprising p-type impurities at 2 × 10¹⁵ cm⁻³ or higher and the other type of semiconductor is an n-type semiconductor comprising n-type impurities at 2 × 10¹⁵ cm⁻³ or higher. The configuration also has an inner i-type layer. The electron emitting portion in the configuration shown in FIGS. 4(a)-(d) is formed by a p-type layer, and employing such a configuration makes it possible to realize an electron emission cathode and electron emission source of high brightness and small energy width.
The configuration shown in FIGS. 4(e)-(g) is composed of a n-type layer, a p-type layer, and an i-type layer, similarly to the above-descried configuration, but the specific feature of the present configuration is that the electron emitting portion is formed by the i-type layer. When the tip end is an i-type layer, a structure is obtained in which electrons are pulled into this tip end and easily accumulated therein. Therefore, a better structure is obtained. The p-type layer plays a role of ensuring a potential for drawing the electrons. In the configuration shown in FIG. 4(g), the p-type layer and n-type layer are joined in the vicinity of the sharpened acute section. Employing such a configuration makes it possible to realize an electron emission cathode and electron emission source of high brightness and small energy width.

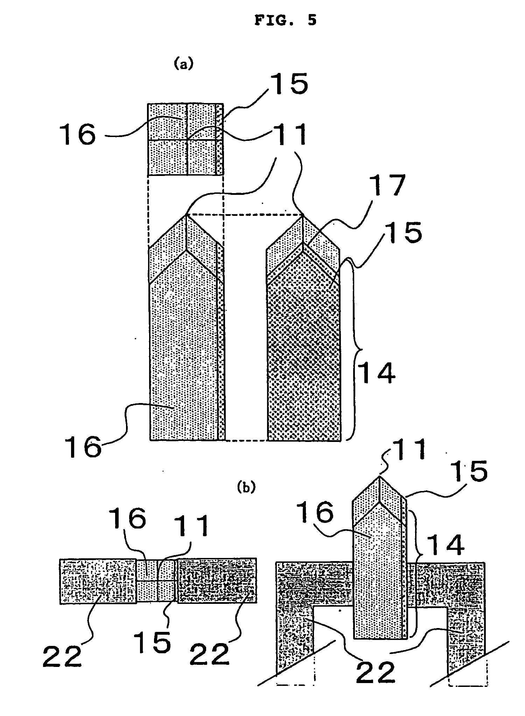

In the case where a potential is applied in the reverse direction in the structure shown in FIGS. 2(a), (b), the depletion layer in the vicinity of the junction tends to spread. Therefore, electrons do not flow until a certain voltage is applied. However, if a certain voltage is exceeded, electron injection from the p-type layer into the n-type layer is started. In the structure shown in figures (a), (b) where the distalmost tip end is constituted by the n-type layer, the direction of such electron injection is likewise toward the sharp tip end, thereby facilitating the electron emission.
The diamond electron emission cathode shown in FIG. 5(a) is composed of two types of semiconductors: a first semiconductor 15 comprising n-type impurities at 2 × 10¹⁵ cm⁻³ or higher and a second semiconductor 16 comprising p-type impurities at 2 × 10¹⁵ cm⁻³ or higher. Those n-type semiconductor and p-type semiconductor are joined as shown in FIG. 5(a). When a voltage is applied by a pair of current introducing terminals 22, 22, as shown in FIG. 5(b), a potential that is negative with respect to the p-type semiconductor is applied to the n-type semiconductor so that electrons flow from the n-type semiconductor to the p-type semiconductor. In the n-type semiconductor, a component is contained which transports the electrons into the electron emitting portion. Thus, as shown in FIG. 5(b), in the diamond electron emission cathode, the first semiconductor 15 and second semiconductor 16 are clamped so as to come into contact with respective pieces of the pair of current introducing terminals 22, 22 and a bias voltage is applied. Under the effect of the bias voltage, electrons flow from the first semiconductor 15 where a large number of electrons are present into the second semiconductor 16 where the number of electrons is comparatively small. Thus, in addition to stabilizing the emission current by heating with the heating section 14 through which an electric current is passed, the electrons supplied from the current introducing terminal 22 to the first semiconductor 15 flow into the conductor of the second semiconductor 16 under the effect of the bias voltage. In the vicinity 17 of the sharply pointed electron emitting portion 11, the direction in which electrons flow from the first semiconductor 15 into the second semiconductor 16 and the direction of extracting the electrons into vacuum sometimes become almost the same direction. In other words, this is, for example, the case where the interface of the first semiconductor 15 and second semiconductor 16 is in the position slightly displaced from the electron emitting portion 11 and the second semiconductor is closer to the tip end. This case is especially preferred because electron emission with even higher current density can be obtained by selecting the second semiconductor 16 that has a difference in energy between the conductor and vacuum level, that is, the electron affinity less than that of the first semiconductor 15.

The diamond electron emission cathode preferably uses a diamond comprising p-type impurities at 2 × 10¹⁵ cm⁻³ or higher. The above-described effect can be obtained at even larger scale by selecting a diamond comprising n-type impurities at 2 × 10¹⁵ cm⁻³ or higher as the first semiconductor 15, selecting a diamond comprising p-type impurities at 2 × 10¹⁵ cm⁻³ or higher as the second semiconductor 16, and applying a bias voltage with a pair of current introducing terminals. Furthermore, because the level of p-type impurities in diamond is shallow and a low resistance can be obtained, in this case the resistance value of the entire cathode becomes even lower. As a result, a voltage drop at the cathode decreases, whereby the electron emission efficiency increases. A B-doped single crystal diamond obtained by high-temperature high-pressure synthesis can be advantageously used.

The diamond electron emission cathode shown in FIG. 1 to FIG. 5 is in a columnar shape with a length in the short side direction of 0.05 mm or more to 2 mm or less and an aspect ratio of 1 or more so that the electron emission cathode can be installed in an electron gun chamber devised as an electron extraction structure of an electron microscope or electron beam exposure device. If the length in the short side direction is less than 0.05 mm, when the diamond electron source is used at a high temperature, due to thermal expansion of a clamping metal in a tool employed for mounting the diamond electron source, it is highly probable that the diamond electron source will fall out from the tool, and if the length in the short side direction is more than 2 mm, the electron emission noise from the outside of the electron emitting portion that decreases the brightness of the obtained electron beam becomes significant, and this noise is difficult to suppress with the suppressor of the electron gun chamber. If the aspect ratio is less than 1, even the electrons emitted from the electron emitting portion are suppressed with the suppressor and a high-brightness electron beam is difficult to obtain.

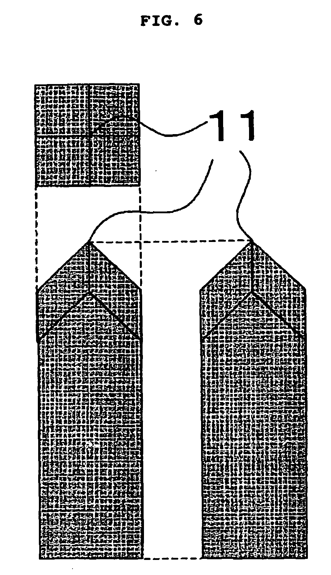

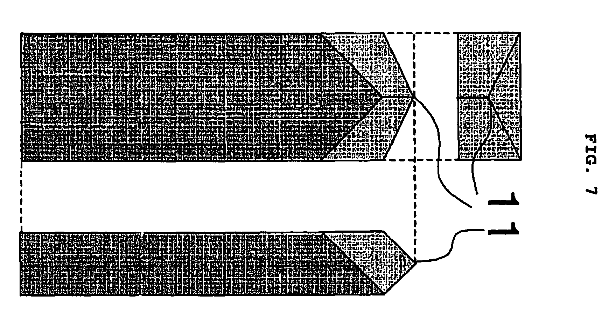

A sharpened acute section having one electron emitting portion will be explained below.
It is preferred that in the surfaces of the diamond 10 constituting the diamond electron emission cathode shown in FIG. 1, at least one plane of the planes which form the sharpened electron emitting portion 11 as an apex is formed by a (111) crystal plane. The stable growth plane in vapor phase growth is a (100) plane or (111) plane, but the intake efficiency of n-type impurities such as P or S of the (111) plane in the vapor phase growth process is 10 or more times that of the (100) plane. Therefore, by performing high-concentration doping of n-type impurities at the (111) plane of diamond, it is possible to realize electron emission with a high current density like on metallic conduction, that is, a high-brightness electron emission cathode. In the advantageous shape of the electron emitting portion 11 comprising the (111) plane, all four planes constituting the sharpened acute section such as shown in the plan view of FIG. 6 are made (111) planes, or two planes of the three planes constituting the sharpened acute section such as shown in the plan view of FIG. 7 are made (111) planes, but even one plane of the planes constituting the sharpened acute section may be the (111) plane. The (111) plane, as referred to herein, includes off-planes within ±7° from the (111) just plane. Within this range, high-concentration doping of n-type impurities can be attained. Examples of methods that can be advantageously used for forming the (111) planes include polishing, laser machining, ion etching, growth, or combinations thereof.

The specific resistance of the portion of the diamond electron emission cathode containing n-type impurities at 300 K is preferably 300 Ωcm or less. In this case, electrons can be effectively supplied to the portion containing n-type impurities, high-density electron emission is possible, and a high brightness electron emission cathode can be obtained.

The tip end curvature radius of the electron emitting portion 11 is preferably 30 µm or less. By making the tip end of the electron emitting portion of such a small size, an electron emission cathode with a higher brightness can be obtained. Furthermore, a smaller focusing point can be maintained when the electron emitting tip is used for a tip of thermal electron emission. If the pointed tip curvature radius is more than 30 µm, the focus point is very difficult to decrease in size and special design should be paid to the optical system of the electron beam device. In order to obtain a sharp tip end, it is preferred that a diamond electrically conductive layer 12 be formed by vapor phase synthesis and then machining be conducted by polishing or ion etching. Furthermore, if the tip end diameter is 5 µm or less, an electric field of 10⁴ V/cm or more can be easily obtained at the tip end of the electron emitting portion 11. Therefore, this tip end diameter is a threshold at which the cathode can be advantageously used as a thermal filed emission cathode. Even more preferred that the tip end diameter be 1 µm or less. In this case, an electric field of 10⁷ V/cm or more can be easily obtained at the tip end of the electron emitting portion 11 and, therefore, the cathode can be advantageously used as a field-emission cathode.

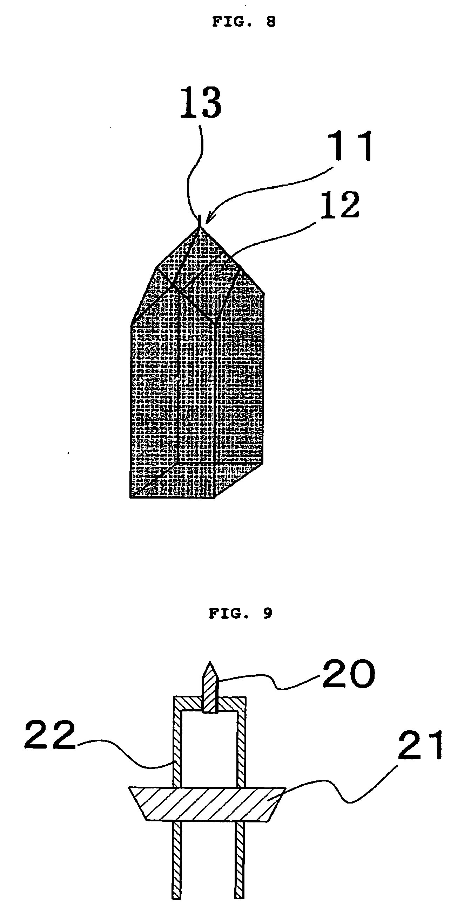

Furthermore, the electron emitting portion 11 may have a protruding structure 13, as shown in FIG. 8, in which the tip end diameter of the protrusion is 5 µm or less and the aspect ratio is 2 or more. In order to obtain such a sharp tip end, it is preferred that a diamond electric conduction layer 12 be formed by vapor phase synthesis and then fine machining be conducted by ion etching. If only the electron emitting portion 11 of the entire diamond signal crystal serving as an electron emission cathode has such a sharpened tip shape, then the cathode can be easily mounted on an electron microscope or electron beam exposure device. If the tip end diameter is 5 µm or less, the cathode can be advantageously used as a high-brightness thermal field emission cathode, and if the tip end diameter is 1 µm or less, the cathode can be advantageously used as a high-brightness field-emission cathode.

Emitting an electron beam with an energy width of 0.6 eV or less under an applied voltage of 0.5 kV or more to 100 kV or less also may be a specific feature of the diamond electron emission cathode in accordance with the present invention. Such diamond electron emission cathode as a replacement for cathodes from the conventional materials can provide a good electron beam.

FIG. 9 is a cross-sectional view of a diamond electron emission source in accordance with the present invention. The diamond electron emission source has a structure comprising the diamond electron emission cathode 20 in accordance with the present invention, an insulating ceramic 21, and a pair of supporting terminals 22 for supplying an electric current to the diamond electron emission cathode 20, wherein the electric resistance value between the terminals in this structure is 3 kΩ or less. In this case, the performance of the diamond electron emission source can be fully demonstrated with a power source system of an electron beam device using the conventional cathode material.

Further, the diamond electron emission source shown in FIG. 9 has a structure comprising the diamond electron emission cathode 20 in accordance with the present invention, insulating ceramic 21, and a pair of supporting terminals 22 for clamping the diamond electron emission cathode 20 and fixing it to the insulating ceramic 21 and for supplying an electric current to the diamond electron emission cathode 20, wherein the supporting terminals 22 are brought into direct contact with the diamond electron emission cathode 20. A metal with a high melting point such as Mo, Ta, or alloys thereof can be advantageously used as a material of the supporting terminals. Because the diamond electron emission cathode 20 does not react with the supporting terminals 22 even at a high temperature under electron emission, the cathode can be clamped by direction contact. With the above-described structure of the diamond electron emission source, the diamond electron emission source may be installed very easily in place of the conventional one in electron beam devices using W filaments, LaB₆, or sharpened W or ZrO/W which are the conventional cathode material. Moreover, because of a structure in which the diamond electron emission cathode is directly clamped by the supporting terminals, the alignment of optical axes during production is facilitated and the possibility of displacement or separation during use is low. Furthermore, an electric resistance of 3 kΩ or less between the terminals at room temperature is desirable for attaching the diamond electron emission cathode to electron beam devices where the conventional cathode materials were used. At a higher resistance value, there is a strong possibility that sufficient electron emission characteristics will not be obtained with the power source of the electron beam device.

The electron microscope in accordance with the present invention has installed therein the diamond electron emission cathode or diamond electron emission source in accordance with the present invention and enables observations at a higher magnification ratio than the electron microscopes using the conventional cathode materials. When the diamond electron emission cathode in accordance with the present invention is so shaped that it can be used as a thermal electron emission cathode and installed in an electron microscope, observations of fine configurations can be performed at a magnification ratio higher than that attained when LaB₆ is used. When the diamond electron emission cathode is so shaped that it can be used as a thermal field emission cathode and installed in an electron microscope, observations of fine configurations can be performed at a magnification ratio higher than that attained when ZrO/W is used. Alternatively when the diamond electron emission cathode is so shaped that it can be used as a field-emitter and installed in an electron microscope, observations of fine configurations can be performed at a magnification ratio higher than that attained when sharpened W is used.

The electron beam exposure device in accordance with the present invention has installed therein the diamond electron emission cathode or diamond electron emission source in accordance with the present invention and enables the drawing of fine patterns with a throughput higher than that of electron beam exposure devices using the conventional cathode materials. When the diamond electron emission cathode in accordance with the present invention is so shaped that it can be used as a thermal electron emission cathode and installed in an electron beam exposure device, fine patterns can be drawn with a throughput higher than that attained when LaB₆ is used. When the diamond electron emission cathode is so shaped that it can be used as a thermal field emission cathode and installed in an electron beam exposure device, fine patterns can be drawn with a throughput higher than that attained when ZrO/W is used.

### EXAMPLES

The diamond electron emission cathode, electron emission source, electron microscope, and electron beam exposure device in accordance with the present invention will be described below in greater detail based on embodiments thereof.

### [EXAMPLE 1]

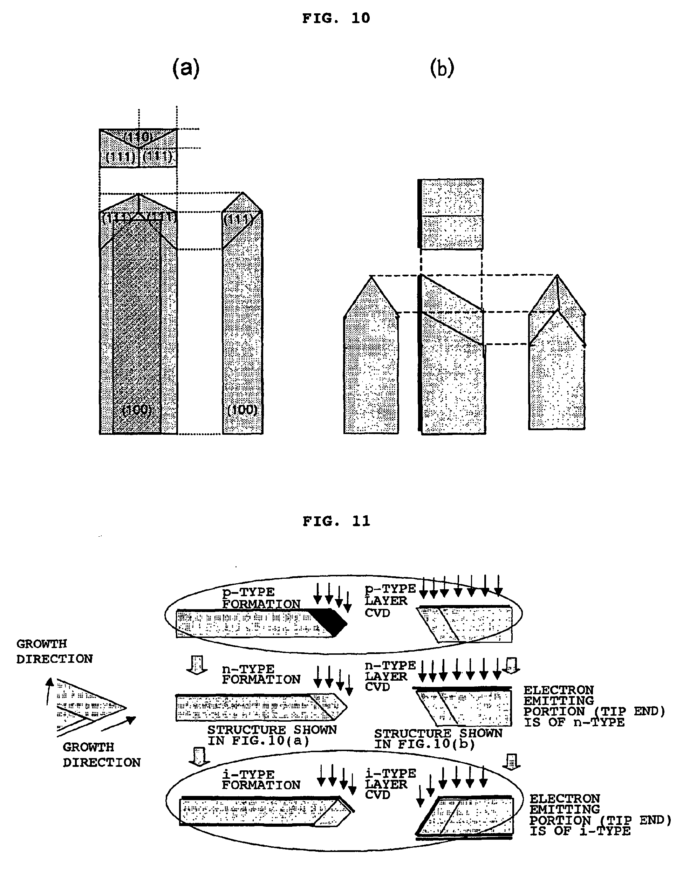

Single crystal diamond substrates obtained by high-pressure synthesis and single crystal substrates obtained by vapor phase synthesis, all having the shape of an elongated rectangular parallelepiped, were subjected to sharpening in order to prepare samples having a sharp tip end, as shown in FIG. 10(a). Diamonds subjected to doping of various types were synthesized on those substrates. The synthesis of diamonds was conducted by a microwave CVD method by using hydrogen gas and methane gas.

The tip end diameter could be roughly adjusted during polishing, and representative samples with a tip end diameter of about 1 µm and about 10 µm were prepared. The tip end can be also sharpened to a submicron level by diamond re-growth or vertical etching using plasma or ions.

When an n-type layer was formed on the (111) plane, the methane concentration (CH₄/H₂), phosphorus concentration (PH₃/CH₄), pressure and substrate temperature were set to 0.03-0.05%, 0.002-20%, 133 hPa (100 Torr) and 870°C, respectively. Under such conditions, the low-resistance n-type layer could be formed only on the (111) plane and practically no film was attached to other planes, or films with a somewhat higher resistance were formed thereon. Such films with a high resistance had a bonding strength lower than the epitaxial diamond film on the (111) plane and could be removed by treating in hydrogen plasma comprising oxygen at 0.1% or less. It goes without saying, that the n-type film and high-resistance film were formed only on the surface of the substrate facing the plasma and could not be formed on the rear surface of the substrate.

When an n-type layer was formed on the (100) plane, the methane concentration, phosphorus concentration and pressure were set to 0.5%, 1-10% and 13.3-66.7 hPa (10-50 Torr), respectively. Although the layer formation rate varied within this pressure range, similar films could be formed. Under such conditions, a high-resistance film could be formed only on the (111) plane, but this high-resistance film on the (111) plane could be etched selectively by hydrogen plasma containing oxygen, as mentioned above.
A boron-doped layer was formed as the p-type film by using B₂H₆ gas. The p-type film could be formed at a methane concentration of 0.1-5% and a diboran concentration (B₂H₆/CH₆) of 10 ppm - 10000 ppm. The film could be formed at a pressure and substrate temperature of 26.7-213 hPa (20-160 Torr) and 750-1000°C, respectively, and the films were formed at representative pressure and temperature of 133 hPa (100 Torr) and close to 870°C. Obviously, the films could be formed on the front surface of the substrates and could not be formed on the rear surface.
Methods for fabricating chips of various structures are shown in FIG. 11. All the substrate were boron-containing substrates with p-type conductivity. An n-type film was formed under the n-type film formation conditions on the (111) plane on a sharpened sample of the shape shown in FIG. 10(a), (b). A single chip with an n-type film formed as far as the tip end could be fabricated by processing the above-described structure, without the necessity to remove a high-resistance film. A sample in which a boron-doped p-type layer was formed by vapor phase synthesis prior to forming the n-type layer was also prepared. Although similar structures of a pn-stack type were obtained, the advantage of the structure was that the junction surface used a CVD film in which the impurities of the p-type layer were accurately controlled. In addition, with the p-type layer obtained by CVD, the characteristics were also better. Further, the produced samples in which the p-type and n-type films were stacked as shown in FIGS. 10(a), (b), had a structure in which the electrodes were brought into contact individually with the n-type and p-type films in the base portion of the chip and the chip current was induced in the pn forward direction. The electric field was applied across the junction surface. The electrodes that were in contact with the p and n-type layers were connected to the metal that was clamping the chip. With such a structure, the substrate could be heated under certain chip voltage and current conditions.
A sample in which an undoped layer (i-type layer) was formed on the n-type layer was also prepared as a separate sample. In this case, no i-type layer was formed on the portion that was to be brought into contact with the electrodes. The effect was demonstrated by forming this layer on the tip end. The i-type layer as referred to herein indicates a film formed on the insulating substrate and having a carrier concentration at a level of 10⁹ cm⁻³ that cannot be measured.

The results relating to electron emission characteristics of the samples are shown in Tables 1-6 below. In all the cases, poor characteristics were obtained in the samples without the chip voltage and the samples without protrusions. Separately from the tests illustrated by the tables, the materials with difference tip end radius and height were studied, and the characteristics tended to improve when the tip end radius was 30 µm or less and the protrusion height exceeded 50 µm.
As described hereinabove, because plane orientation in the sample is an extremely important factor, substrates in which plane orientation cannot be controlled in the chip sample, for example polycrystalline substrates, are unsuitable from the standpoint of the present invention. Not only single crystal substrates, but also high-orientation substrates or hetero-substrates can be also used, provided that the plane orientation can be controlled.
All the tests were conducted on chips with hydrogen-terminated surface, and the emission current characteristic of the chips with hydrogen-terminated surface was improved by almost 30-50% with respect to that of the chips with oxygen-terminated surface. Furthermore, the length in the short side direction of the chip was set mainly to 0.05-1 mm; properties could not be evaluated at a length more than 2 mm and less than 0.05 mm. The resistance between the terminals was set to 10 Ω - 3 kΩ; no electron emission was possible when the resistance was outside this range. The resistance between the terminals could be controlled by the thickness of the n-type layer or p-type layer or the doping concentration, and even when the layer thickness or concentration were constant, the resistance still could be controlled by a metal coating.
The metal coating usually was formed individually on both the p-type layer and the n-type layer, or only on one layer. The coating was effective when the film resistance of the layers was high. For example, the metal coating had the structure shown in FIG. 10(a). When the coating was formed to the vicinity of the tip end within a range of 500 µm or less from the tip end so that it reached the vicinity of the tip end, electrons effectively traveled as far as the vicinity of the tip end. As a result, the emission current value increased by 100% at an n-type impurity concentration of 10¹⁶ cm⁻³ and by 20% at a concentration of 10¹⁸ cm⁻³.
As another method for metal coating, a method of coating so that the p-type layer and n-type layer become conductive at the same time was also found to be effective. If the layers are made conductive with the coating metal, no potential is applied to the p-type layer or n-type layer. Accordingly, such approach was thought to be ineffective. However, in practice, since the coating metal was thin, a resistance component was existent, an electric current flowed to the metal portion under the applied voltage and an electric potential could be generated at the n-type layer side and p-type layer side. In this case, the n-type layer or p-type layer operated effectively in the case of a low impurity concentration, the resistance between the terminals could be reduced to 700 Ω or less, and a characteristic similar to that shown in Table 5 could be maintained. At a higher resistance, the characteristic degraded. On the other hand, when the resistance between the terminals was 10 Ω or less, the desired electric potential in the pn junction could not be ensured and the emission characteristic also greatly degraded.

**Table 1**

| | | | | | | | | | | |
|---|---|---|---|---|---|---|---|---|---|---|
| Sample conditions: | | | | | | Measurement Conditions: | | | | |
| n-Type impurity concentration: 10¹⁸ cm⁻³ | | | | | | Accelerating voltage: 15 kV | | | | |
| p-Type impurity concentration: 10¹⁸ cm⁻³ | | | | | | | | | | |
| n, p type of the tip end: n-type or i-type | | | | | | | | | | |
| Tip end curvature radius of the sample: 10 µm | | | | | | | | | | |
| Diode characteristics between terminals | | | | | | | | | | |
| Sample temperature: about room temperature | | | | | | | | | | |

| Sample shape | Structure shown in FIG. 10(a) | | Structure shown in FIG. (10a) | | Structure shown in FIG. 10(b) | | Structure shown in FIG. 10(b) | | R-type | |
|---|---|---|---|---|---|---|---|---|---|---|
| Electron emitting portion | n-type | | i-type | | n-type | | i-type | | p-type Tip end curvature was ∞ | |
| Chip voltage (V) n: -, p: + | 40 | 0 | 40 | 0 | 50 | 0 | 50 | 0 | 50 | 0 |
| Emission current (µA) | 30 | 0 | 50 | 0 | 20 | 0 | 40 | 0 | 0.001 | 0 |
| Brightness (A/cm²/sr) | 5×10⁶ | 0 | 7×10⁶ | 0 | 4×10⁶ | 0 | 6×10⁶ | 0 | 3×10¹ | 0 |
| Energy width (eV) | 0.25 | - | 0.2 | - | 0.3 | - | 0.2 | - | Beam was not converged, measurements were impossible | - |

**Table 2**

| | | | | | | | | | | |
|---|---|---|---|---|---|---|---|---|---|---|
| Sample conditions: | | | | | | Measurement conditions: | | | | |
| n-Type impurity concentration: 10¹⁸ cm⁻³ | | | | | | Accelerating voltage: 15 kV | | | | |
| p-Type impurity concentration: 10¹⁸ cm⁻³ | | | | | | | | | | |
| n, p type of the tip end: n-type or i-type | | | | | | | | | | |
| Tip end curvature radius of the sample: 1 µm | | | | | | | | | | |
| Diode characteristics between terminals | | | | | | | | | | |
| Sample temperature: about room temperature | | | | | | | | | | |

| Sample shape | Structure shown in FIG. 10(a) | | Structure shown in FIG 10(a) | | Structure shown in FIG. 10(b) | | Structure shown in FIG. 10(b) | | R-type | |
|---|---|---|---|---|---|---|---|---|---|---|
| Electron emitting portion | n-type | | i-type | | n-type | | i-type | | p-type Tip end curvature was ∞ | |
| Chip voltage (V) n: -, p: + | 40 | 0 | 40 | 0 | 50 | 0 | 50 | 0 | 50 | 0 |
| Emission current (µA) | 13 | 0 | 24 | 0 | 10 | 0 | 25 | 0 | 0.001 | 0 |
| Brightness (A/cm² /sr) | 1×10⁷ | 0 | 2×10⁷ | 0 | 1×10⁷ | 0 | 3×10⁷ | 0 | 3×10¹ | 0 |
| Energy width (eV) | 0.25 | - | 0.2 | - | 0.3 | - | 0.2 | - | Beam was not converged, measurements were impossible | - |

**Table 3**

| | | | | | | | | |
|---|---|---|---|---|---|---|---|---|
| Sample conditions: | | | | | Measurement conditions: | | | |
| n-Type impurity concentration: 10²⁰ cm⁻³ | | | | | Accelerating voltage: 15 kV | | | |
| p-Type impurity concentration: 10¹⁹ cm⁻³ | | | | | | | | |
| n, p type of the tip end: n-type or i-type | | | | | | | | |
| Tip end curvature radius of the sample: 10 µm | | | | | | | | |
| Diode characteristics between terminals | | | | | | | | |
| Sample temperature: about 500°C | | | | | | | | |

| Sample shape | Structure shown in FIG. 10(a) | | Structure shown in FIG. 10(a) | | Structure shown in FIG. 10(b) | | Structure shown in FIG. 10(b) | |
|---|---|---|---|---|---|---|---|---|
| Electron emitting portion | n-type | | i-type | | n-type | | i-type | |
| Chip voltage (V) n: -, p: + | 15 | 0 | 15 | 0 | 10 | 0 | 10 | 0 |
| Emission current (µA) | 50 | <1 | 80 | <1 | 40 | <1 | 60 | <1 |
| Brightness (A/cm²/sr) | 8×10⁶ | <10⁴ | 9×10⁶ | <10⁴ | 8×10⁶ | <10⁴ | 1×10⁷ | <10⁴ |
| Energy width (eV) | 0.35 | - | 0.35 | - | 0.35 | - | 0.35 | - |

**Table 4**

| | | | | | | | | |
|---|---|---|---|---|---|---|---|---|
| Sample conditions: | | | | | Measurement conditions: | | | |
| n-Type impurity concentration: 10²⁰ cm⁻³ | | | | | Accelerating voltage: 15 kV | | | |
| p-Type impurity concentration: 10¹⁹ cm⁻³ | | | | | | | | |
| n, p type of the tip end: n-type or i-type | | | | | | | | |
| Tip end curvature radius of the sample: 1 µm | | | | | | | | |
| Diode characteristics between terminals | | | | | | | | |
| Sample temperature: about 500°C | | | | | | | | |

| Sample shape | Structure shown in FIG. 10(a) | | Structure shown in FIG. 10(a) | | Structure shown in FIG. 10(b) | | Structure shown in FIG. 10(b) | |
|---|---|---|---|---|---|---|---|---|
| Electron emitting portion | n-type | | i-type | | n-type | | i-type | |
| Chip voltage (V) n: -, p: + | 15 | 0 | 15 | 0 | 10 | 0 | 10 | 0 |
| Emission current (µA) | 16 | <1 | 30 | <1 | 20 | <1 | 35 | <1 |
| Brightness (A/cm²/sr) | 2×10⁷ | <10⁴ | 3×10⁷ | <10⁴ | 2×10⁷ | <10⁴ | 4×10⁷ | <10⁴ |
| Energy width (eV) | 0.35 | - | 0.35 | - | 0.35 | - | 0.35 | - |

**Table 5**

| | | | | | | | | | | |
|---|---|---|---|---|---|---|---|---|---|---|
| Sample conditions: | | | | | | Measurement conditions: | | | | |
| p-Type impurity concentration: 10¹⁹ cm⁻³ | | | | | | Accelerating voltage: 15 kV | | | | |
| n, p type of the tip end: n-type | | | | | | | | | | |
| Tip end curvature radius of the sample: 10 µm | | | | | | | | | | |
| Diode characteristics between terminals | | | | | | | | | | |
| Sample temperature: room temperature, 500°C | | | | | | | | | | |

| Sample shape | Structure shown in FIG. 10(a) | | Structure shown in FIG. 10(a) | | Structure shown in FIG. 10(a) | | Structure shown in FIG. 10(a) | | Structure shown in FIG. 10(a) | |
|---|---|---|---|---|---|---|---|---|---|---|
| n-Type impurity (cm⁻³) | 10¹⁵ | | 10¹⁶ | | 10¹⁸ | | 10²⁰ | | 10¹⁵ | 10¹⁶ |
| Electron emitting portion | n-type | | n-type | | n-type | | n-type | | n-type | n-type |
| Sample temperature (°C) | Room temp. | Room temp. | Room temp. | Room temp. | Room temp. | Room temp. | Room temp. | Room temp. | 500 | 500 |
| Chip voltage (V) N: -, p: + | 100 | 0 | 80 | 0 | 40 | 0 | 10 | 0 | 50 | 30 |
| Emission current (µA) | 0 | 0 | 5 | 0 | 40 | 0 | 30 | <1 | 0 | 10 |
| Brightness (A/cm²/sr) | 0 | 0 | 5 | 0 | 6×10⁶ | 0 | 4×10⁶ | <10⁴ | 0 | 1×10⁶ |
| Energy width (eV) | - | - | 0.2 | - | 0.25 | - | 0.25 | - | - | 0.35 |

**Table 6**

| | | | | | | | | | | |
|---|---|---|---|---|---|---|---|---|---|---|
| Sample conditions: | | | | | | Measurement conditions: | | | | |
| n-Type impurity concentration: 10²⁰ cm⁻³ | | | | | | Accelerating voltage: 15 kV | | | | |
| n, p type of the tip end: n-type | | | | | | | | | | |
| Tip end curvature radius of the sample: 10 µm | | | | | | | | | | |
| Diode characteristics between terminals | | | | | | | | | | |
| Sample temperature: room temperature, 500°C | | | | | | | | | | |

| Sample shape | Structure shown in FIG. 10(a) | | Structure shown in FIG. 10(a) | | Structure shown in FIG. 10(a) | | Structure shown in FIG . 10(a) | | Structure shown in FIG. 10(a) | |
|---|---|---|---|---|---|---|---|---|---|---|
| p-Type impurity(cm⁻³) | 10¹⁵ | | 10¹⁶ | | 10¹⁸ | | 10²⁰ | | 10¹⁵ | 10¹⁶ |
| Electron emitting portion | n-type | | n-type | | n-type | | n-type | | n-type | n-type |
| Sample temperature (°C) | Room temp. | Room temp. | Room temp. | Room temp. | Room temp. | Room temp. | Room temp. | Room temp. | 500 | 500 |
| Chip voltage (V) Chip voltage (V) n: -, p: + | 100 | 0 | 80 | 0 | 40 | 0 | 10 | 0 | 30 | 10 |
| Emission current (µA) | <1 | <1 | 10 | <1 | 40 | <1 | 35 | <1 | <1 | 30 |
| Brightness (A/cm²/sr) | 0 | <10⁴ | 1×10⁶ | <10⁴ | 6×10⁶ | <10⁴ | 5×10⁶ | <10⁴ | <10⁴ | 4×10⁶ |
| Energy width (Ev) | - | - | 0.2 | - | 0.25 | - | 0.25 | - | - | 0.35 |

### EXAMPLE 2

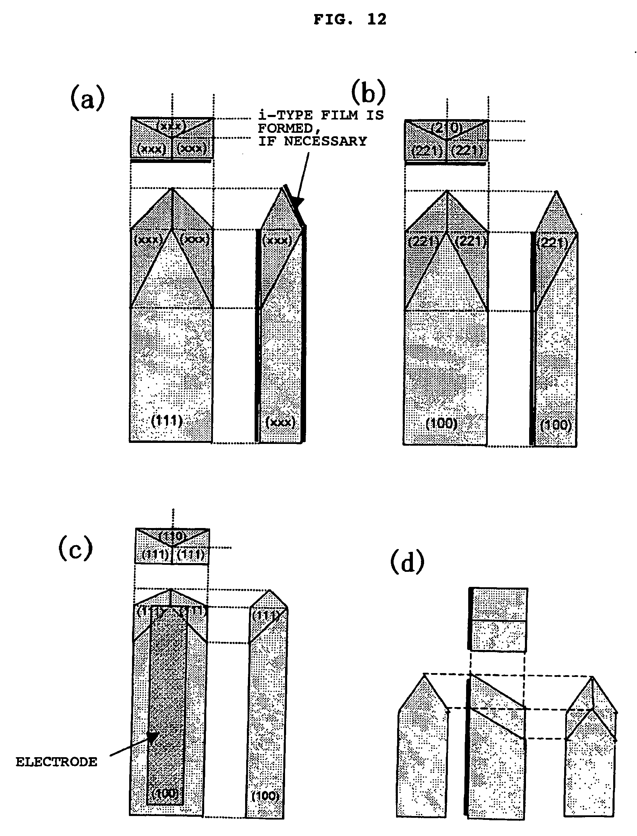

Single crystal diamond substrates obtained by high-pressure synthesis and single crystal substrate obtained by vapor phase synthesis, all having the shape of an elongated rectangular parallelepiped, were subjected to sharpening in order to prepare samples having a sharp tip end, as shown in FIG. 12(a)-(d). Diamonds subjected to doping of various types were synthesized on those substrates. The synthesis of diamonds was conducted by a microwave CVD method by using hydrogen gas and methane gas.
The tip end diameter could be roughly adjusted during polishing, and representative samples with a tip end diameter of about 1 µm and about 10 µm were prepared. The tip end can be also sharpened to a submicron level by diamond re-growth or vertical etching using plasma or ions.
The conditions of forming a n-type layer on the (111) plane, forming a n-type layer on the (100) surface, and forming a p-type film were identical to those of Example 1.
All the substrates were boron-containing substrates with p-type conductivity. An n-type film was formed on the (111) plane under the conditions relating to the (111) plane on the sharpened samples of the shape shown in FIG. 12(a), and the film formed on the remaining planes was removed by the above-described plasma treatment. As a result, a single chip with a p-type tip end portion and a n-type film formed half way to the tip end portion was produced. By contrast, an n-type film was formed under the n-type formation conditions on the (100) plane in the sharpened sample shown in FIG. 12(b).

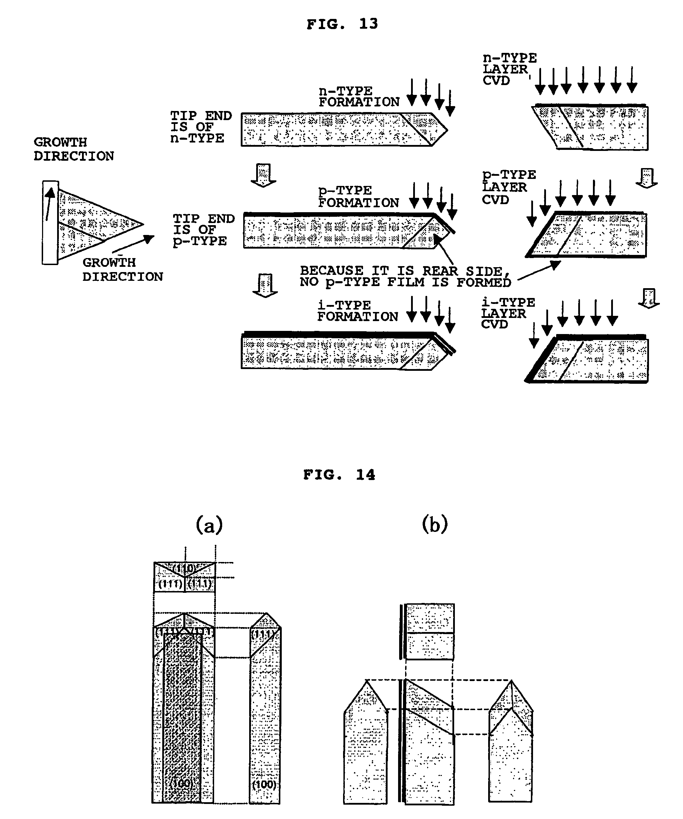

The film formed on the remaining planes was removed by the above-described plasma treatment. As a result, a single chip with a p-type tip end portion and an n-type film formed half way to the tip end portion was produced. Further, the produced samples in which the p-type and n-type films were stacked as shown in FIGS. 12(a) and (b) had a structure in which the electrodes were brought into contact individually with the n-type and p-type films in the base portion of the chip and the chip current was induced in the pn forward direction. The electrodes that were in contact with the pn-type layers were connected to the metal that was clamping the chip. With such a structure, the substrate can be heated under certain chip voltage and current conditions.
An n-type film was formed under the n-type film formation conditions on the (111) plane on the sharpened samples of the shape shown in FIGS. 12(c), (d). FIG. 13 illustrates the manufacturing method thereof. The high-resistance layer that was formed at the same time was not treated, the sample was reversed, and a p-type layer was formed. As a result, a protrusion with a p-type tip end was obtained. On the reverse side, a p-type film was not formed. FIG. 12(d) illustrates the structure of a completed sample in which an electric current is caused to flow in the pn forward direction, as in (a) or (b). In the completed sample shown in (c), the surface area of the n-type layer was small, and the n-type layer was not present at the base. Therefore, as shown in the figure, the electrode was formed as far as the n-type layer from the base. Because a high-resistance film was formed on the p-type layer of the base, a structure was produced in which there was no contact with the p-type layer. When the breakdown voltage was insufficient, a SiO₂ layer was formed on the base side.
As a result, an emitter having an n-type layer and a p-type layer tip end was produced in all the samples and the same structure as described above in which an electric current was caused to flow in the pn forward direction was obtained. With such a structure, the substrate could be heated under certain chip voltage and current conditions.

The results relating to electron emission characteristics of the samples are shown in Tables 7-11 below. In all the cases, poor characteristics were obtained in the samples without the chip voltage and the samples without protrusions. The characteristics tended to improve when the tip end radius was 30 µm or less and the protrusion height exceeded 50 µm, in the same manner as in Example 1.
As described hereinabove, because plane orientation in the sample is an extremely important factor, substrates in which plane orientation cannot be controlled in the chip sample, for example polycrystalline substrates, are unsuitable from the standpoint of the present invention. Not only single crystal substrates, but also high-orientation substrates or hetero-substrates can be also used, provided that the plane orientation can be controlled.
Finally, an undoped i-type layer was formed on the p-type layer to obtain an npi structure with a pn-junction. In sample (c) and sample (d) with a chip structure in which the tip end was an i-type layer, the emission current was increased by 20-50%. The structure in which the i-type layer was present on the tip end of the outermost surface was effective. Using the single crystal substrate obtained by vapor phase growth increased the emission current value by about 30% with respect to that attained by using the single crystal diamond substrate obtained by high-pressure synthesis.
Comparing with Example 1, in the protruding chip with an np-junction, the characteristics can be said to be better with a p-type tip end than an n-type tip end. Furthermore, using a boron-doped bulk substrate obtained by vapor phase synthesis improved the characteristics over those obtained by using a boron-doped substrate obtained by high-pressure synthesis.
All the tests were conducted on chips with hydrogen-terminated surface, and the emission current characteristic of the chips with hydrogen-terminated surface was improved by almost 30-50% with respect to that of the chips with oxygen-terminated surface. Furthermore, the length in the short side direction of the chip was set mainly to 0.5-1 mm; the properties could not be evaluated at a length more than 2 mm and less than 0.05 mm. The resistance between the terminals was set to 10 Ω - 3 kΩ; no electron emission possible when the resistance was outside this range. The resistance between the terminals could be controlled by the thickness of the n-type layer or p-type layer or the doping concentration, and when the layer thickness or concentration were constant, the resistance still could be controlled by a metal coating.

**Table 7**

| | | | | | | | | | | |
|---|---|---|---|---|---|---|---|---|---|---|
| Sample conditions: | | | | | | Measurement conditions: | | | | |
| n-Type impurity concentration: 10¹⁸ cm⁻³ | | | | | | Accelerating voltage: 15 kV | | | | |
| p-Type impurity concentration: 10¹⁸ cm⁻³ | | | | | | | | | | |
| n, p type of the tip end: p-type | | | | | | | | | | |
| Tip end curvature radius of the sample: 10 µm | | | | | | | | | | |
| Diode characteristics between terminals | | | | | | | | | | |
| Sample temperature: about room temperature | | | | | | | | | | |

| Sample shape | Structure shown in FIG. 12(a) | | Structure shown in FIG. 12(b) | | Structure shown in FIG. 12 (c) without insulating layer | | Structure shown in FIG. 12(c) with insulating layer | | Structure shown in FIG. 12(d) | |
|---|---|---|---|---|---|---|---|---|---|---|
| Between electron emitting portion and (111)plane | Apart | | Apart | | Close | | Close | | Close | |
| Chip voltage (V) n: -, p: + | 50 | 0 | 50 | 0 | 40 | 0 | 30 | 0 | 50 | 0 |
| Emission current (µA) | 100 | 0 | 100 | 0 | 200 | 0 | 300 | 0 | 130 | 0 |
| Brightness (A/cm²/sr) | 5×10⁶ | 0 | 5×10⁶ | 0 | 3×10⁷ | 0 | 5×10⁷ | 0 | 2×10⁷ | 0 |
| Energy width (eV) | 0.2 | - | 0.2 | - | 0.25 | - | 0.25 | - | 0.25 | - |

**Table 8**

| | | | | | | | | | | |
|---|---|---|---|---|---|---|---|---|---|---|
| Sample conditions: | | | | | | Measurement conditions: | | | | |
| n-Type impurity concentration: 10¹⁸ cm⁻³ | | | | | | Accelerating voltage: 15 kV | | | | |
| p-Type impurity concentration: 10¹⁸ cm⁻³ | | | | | | | | | | |
| n, p type of the tip end: p-type | | | | | | | | | | |
| Tip end curvature radius of the sample: 1 µm | | | | | | | | | | |
| Diode characteristics between terminals | | | | | | | | | | |
| Sample temperature: about room temperature | | | | | | | | | | |

| Sample shape | Structure shown in FIG. 12(a) | | Structure shown in FIG. 12 (b) | | Structure shown in 12(c) without insulating layer | | Structure shown in FIG. 12 (c) with insulating layer | | Structure shown in FIG. 12(d) | |
|---|---|---|---|---|---|---|---|---|---|---|
| Between electron emitting portion and (111) plane | Apart | | Apart | | Close | | Close | | Close | |
| Chip voltage (V) n: -, p: + | 50 | 0 | 50 | 0 | 40 | 0 | 30 | 0 | 50 | 0 |
| Emission current (µA) | 50 | 0 | 50 | 0 | 110 | 0 | 150 | 0 | 50 | 0 |
| Brightness (A/cm²/sr) | 5×10⁷ | 0 | 5×10⁷ | 0 | 1×10⁸ | 0 | 2×10⁸ | 0 | 8×10⁷ | 0 |
| Energy width (eV) | 0.2 | - | 0.2 | - | 0.25 | - | 0.25 | - | 0.25 | - |

**Table 9**

| | | | | | | | | | | |
|---|---|---|---|---|---|---|---|---|---|---|
| Sample conditions: | | | | | | Measurement conditions: | | | | |
| n-Type impurity concentration: 10²⁰ cm⁻³ | | | | | | Accelerating voltage: 15 kV | | | | |
| p-Type impurity concentration: 10¹⁹ cm⁻³ | | | | | | | | | | |
| n, p type of the tip end: p-type | | | | | | | | | | |
| Tip end curvature radius of the sample: 10 µm | | | | | | | | | | |
| Diode characteristics between terminals | | | | | | | | | | |
| Sample temperature: about 500°C | | | | | | | | | | |

| Sample shape | Structure shown in FIG. 12(a) | | Structure shown in FIG. 12 (b) | | Structure shown in FIG. 12(c). without insulating layer | | Structure shown in FIG. 12(c) with insulating layer | | Structure shown in FIG. 12(d) | |
|---|---|---|---|---|---|---|---|---|---|---|
| Between electron emitting portion and (111)plane | Apart | | Apart | | Close | | Close | | Close | |
| Chip voltage (V) n: -, p: + | 10 | 0 | 10 | 0 | 15 | 0 | 16 | 0 | 10 | 0 |
| Emission current (µA) | 150 | <1 | 150 | <1 | 200 | <1 | 250 | <1 | 150 | <1 |
| Brightness (A/cm²/sr) | 8×10⁶ | <10⁴ | 8×10⁶ | <10⁴ | 3×10⁷ | <10⁴ | 3×10⁷ | <10⁴ | 3×10⁷ | <10⁴ |
| Energy width (eV) | 0.3 | - | 0.3 | - | 0.35 | - | 0.35 | - | 0.35 | - |

**Table 10**

| | | | | | | | | | | |
|---|---|---|---|---|---|---|---|---|---|---|
| Sample conditions: | | | | | Measurement conditions: | | | | | |
| n-Type impurity concentration: 10²⁰ cm⁻³ | | | | | Accelerating voltage: 15 kV | | | | | |
| p-Type impurity concentration: 10¹⁹ cm⁻³ | | | | | | | | | | |
| n, p type of the tip end: p-type | | | | | | | | | | |
| Tip end curvature radius of the sample: 1 µm | | | | | | | | | | |
| Diode characteristics between terminals | | | | | | | | | | |
| Sample temperature: about 500°C | | | | | | | | | | |

| Sample shape | Structure shown in FIG. 12(a) | | Structure shown in FIG. 12 (b) | | Structure shown in FIG. 12(c) without insulating layer | | Structure shown in FIG. 12(c) with insulating layer | | Structure shown in FIG. 12(d) | |
|---|---|---|---|---|---|---|---|---|---|---|
| Between electron emitting portion and (111)plane | Apart | | Apart | | Close | | Close | | Close | |
| Chip voltage (V) n:-, p:+ | 10 | 0 | 10 | 0 | 15 | 0 | 16 | 0 | 10 | 0 |
| Emission current (µA) | 70 | <1 | 70 | <1 | 120 | <1 | 140 | <1 | 80 | <1 |
| Brightness (A/cm²/sr) | 7×10⁷ | <10⁴ | 7×10⁷ | <10⁴ | 1×10⁸ | <10⁴ | 2×10⁸ | <10⁴ | 8×10⁷ | <10⁴ |
| Energy width (eV) | 0.3 | - | 0.3 | - | 0.3 | - | 0.3 | - | 0.3 | - |

**Table 11**

| Sample shape Structure shown in FIG. 12(a) | (1) | | (2) | | (3) | | (4) | |
|---|---|---|---|---|---|---|---|---|
| n-Type impurity (cm⁻³) | 10¹⁵ | | 10¹⁶ | | 10²⁰ | | 10²⁰ | |
| p-Type impurity (cm⁻³) | 10¹⁹ | | 10¹⁹ | | 10¹⁵ | | 10¹⁶ | |
| Electron emitting portion | p-type | | p-type | | p-type | | p-type | |
| Sample temperature (°C) | Room temp. | 500 | Room temp. | 500 | Room temp. | 500 | Room temp. | 500 |
| Chip voltage (V) n: -, p: + | 100 | 50 | 60 | 20 | 100 | 30 | 80 | 10 |
| Emission current (µA) | 0 | 0 | 10 | 40 | <1 | <1 | 20 | 100 |
| Brightness (A/cm²/sr) | 0 | 0 | 8×10⁵ | 3×10⁶ | <10⁴ | <10⁴ | 1×10⁶ | 5×10⁶ |
| Energy width (eV) | - | - | 0.2 | 0.35 | - | - | 0.2 | 0.35 |

### EXAMPLE 3

As shown in FIG. 14(a), (b), samples were prepared in which the tip end of the samples had been sharpened in the same manner as in Example 1. The difference between this example and Example 1 was that an i-type layer that was not doped with impurities was formed prior to the formation of the n-type layer. In all other aspects, the structures were identical, and the tests were carried out under the same doping conditions.
With this method chips having with a tip end in the form of an n-type layer and a pin stack were fabricated.
Similarly to Example 1, a sample in which a boron-doped p-type layer was formed prior to the formation of the i-type layer was also prepared. Although similar structures of a pin-stack type were obtained, the advantage of the latter structure was that the junction surface could use a CVD film in which the impurities of the p-type layer were accurately controlled. Another feature identical to that of Example 1 was that the produced samples in which the p-type and n-type films were stacked as shown in figures (a), (b) had a structure in which the electrodes were brought into contact individually with the n-type and p-type films in the base portion of the chip and the chip current was induced in the pn forward direction. The electric field was applied across the junction surface. Usually, no electric current flows in the i-type layer, but if an electric field is applied in a state where this layer is sandwiched between a p-type layer and n-type layer, the current flows through the i-type layer. The electrodes that were in contact with the p and n-type layers were connected to the metal that was clamping the chip. With such a structure, the substrate can be heated under certain chip voltage and current conditions.

A sample in which an undoped layer (i-type layer) was formed on the n-type layer was also prepared as a separate sample. In this case, no i-type layer was formed on the portion that was to be brought into contact with the electrode. The effect was demonstrated by forming this layer on the tip end. The i-type layer as referred to herein indicates a film formed on the insulating substrate and having a carrier concentration at a level of 10⁹ cm⁻³ that cannot be measured.
The results relating to electron emission characteristics of the samples are shown in Tables 12-14 below. In all the cases, poor characteristics were obtained in the samples without the chip voltage and the samples without protrusions. Similarly to Example 1, the characteristics tended to improve when the tip end radius was 30 µm or less and the protrusion height exceeded 50 µm.
As described hereinabove, because plane orientation in the sample is an extremely important factor, substrates in which plane orientation cannot be controlled in the chip sample, for example polycrystalline substrates, are unsuitable from the standpoint of the present invention. Not only single crystal substrates, but also high-orientation substrates or hetero-substrates can be also used, provided that the plane orientation can be controlled.
As shown in Table 13, using a single crystal substrate obtained by vapor phase growth increased the emission current value with respect to that attained by using a single crystal diamond substrate obtained by high-pressure synthesis, and it was also effective to perform vapor phase synthesis on a single crystal obtained by high-pressure synthesis.
All the tests were conducted on chips with hydrogen-terminated surface, and the emission current characteristic of the chips with hydrogen-terminated surface was improved by almost 30-50% with respect to that of the chips with oxygen-terminated surface. Furthermore, the length in the short side direction of the chip was set mainly to 0.5-1 mm; properties could not be evaluated at a length more than 2 mm and less than 0.05 mm. The resistance between the terminals was set to 10 Ω - 3 kΩ; no electron emission was possible when the resistance was outside this range. The resistance between the terminals could be controlled by the thickness of the n-type layer or p-type layer and the doping concentration, and even when the layer thickness or concentration were constant, the resistance still could be controlled by a metal coating.

**Table 12**

| | | | | | | | | | | |
|---|---|---|---|---|---|---|---|---|---|---|
| Sample conditions: | | | | | Measurement conditions: | | | | | |
| n-Type impurity concentration: 10¹⁸ cm⁻³ | | | | | Accelerating voltage: 15 kV | | | | | |
| p-Type impurity concentration: 10¹⁸ cm⁻³ | | | | | | | | | | |
| n, p type of the tip end: n-type or i-type | | | | | | | | | | |
| Tip end curvature radius of the sample: 10 µm | | | | | | | | | | |
| Diode characteristics between terminals | | | | | | | | | | |
| Sample temperature: about room temperature | | | | | | | | | | |

| Sample shape | Structure shown in FIG. 14(a) | | Structure shown in FIG. 14(a) | | Structure shown in FIG. 14(b) | | Structure shown in FIG. 14(b) | | S-type | |
|---|---|---|---|---|---|---|---|---|---|---|
| Electron emitting portion | n-type | | i-type (outermost surface) | | n-type | | i-type (outermost surface) | | p-type Tip end curvature was ∞ | |
| Chip voltage (V) n: -, p: + | 40 | 0 | 40 | 0 | 50 | 0 | 50 | 0 | 50 | 0 |
| Emission current (µA) | 50 | 0 | 70 | 0 | 40 | 0 | 60 | 0 | 0.002 | 0 |
| Brightness (A/cm²/sr) | 8×10⁶ | 0 | 1.1×10⁷ | 0 | 7×10⁶ | 0 | 9×10⁶ | 0 | 5×10¹ | 0 |
| Energy width (Ev) | 0.25 | - | 0.2 | - | 0.3 | - | 0.2 | - | Beam was not converged, measurements were impossible | - |

**Table 13**

| | | | | | | |
|---|---|---|---|---|---|---|
| Sample conditions: | | | | Measurement conditions: | | |
| n-Type impurity concentration: 10¹⁸ cm⁻³ | | | | Accelerating voltage: 15 kV | | |
| p-Type impurity concentration: 10¹⁸ cm⁻³ | | | | | | |
| n, p type of the tip end: n-type | | | | | | |
| Tip end curvature radius of the sample: 10 µm | | | | | | |
| Diode characteristics between terminals | | | | | | |
| Sample temperature: about room temperature | | | | | | |

| Sample shape | Structure shown in FIG. 14(a) | | Structure shown in FIG. 14(a) | | Structure shown in FIG. 14(a) | |
|---|---|---|---|---|---|---|
| p-type side | Bulk substrate obtained by high-pressure synthesis | | Bulk substrate obtained by vapor phase vapor phase synthesis (CVD) | | Epitaxial film obtained by vapor phase synthesis (CVD) on bulk substrate obtained by high-pressure synthesis | |
| Electron emitting portion | n-type | | n-type | | n-type | |
| Chip voltage (V) n: -, p: + | 40 | 0 | 40 | 0 | 50 | 0 |
| Emission current (µA) | 50 | 0 | 100 | 0 | 70 | 0 |
| Brightness (A/cm²/sr) | 8×10⁶ | 0 | 2×10⁷ | 0 | 1×10⁷ | 0 |
| Energy width (eV) | 0.25 | - | 0.2 | - | 0.25 | - |

**Table 14**

| | | | | | | | | |
|---|---|---|---|---|---|---|---|---|
| Sample conditions: | | | | | Measurement conditions: | | | |
| n-Type impurity concentration: 10²⁰ cm⁻³ | | | | | Accelerating voltage: 15 kV | | | |
| p-Type impurity concentration: 10¹⁹ cm⁻³ | | | | | | | | |
| n, p type of the tip end: n-type or i-type | | | | | | | | |
| Tip end curvature radius of the sample: 10 µm | | | | | | | | |
| Diode characteristics between terminals | | | | | | | | |
| Sample temperature: about 500°C | | | | | | | | |

| Sample shape | Structure shown in FIG. 14(a) | | Structure shown in FIG. 14(a) | | Structure shown in FIG. 14(b) | | Structure shown in FIG. 14(b) | |
|---|---|---|---|---|---|---|---|---|
| Electron emitting portion | n-type | | i-type | | n-type | | i-type | |
| Chip voltage (V) n: -, p: + | 15 | 0 | 15 | 0 | 10 | 0 | 10 | 0 |
| Emission current (µA) | 80 | <1 | 100 | <1 | 80 | <1 | 110 | <1 |
| Brightness (A/cm²/sr) | 1×10⁷ | <10⁴ | 1.5×10⁷ | <10⁴ | 1×10⁷ | <10⁴ | 2×10⁷ | <10⁴ |
| Energy width (eV) | 0.35 | - | 0.35 | - | 0.35 | - | 0.35 | - |

### Example 4

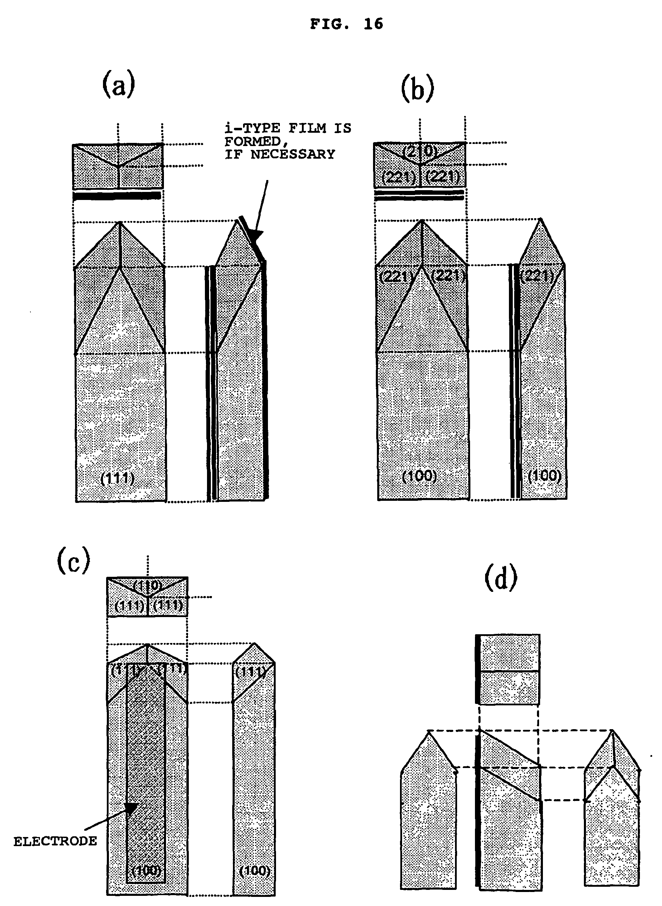

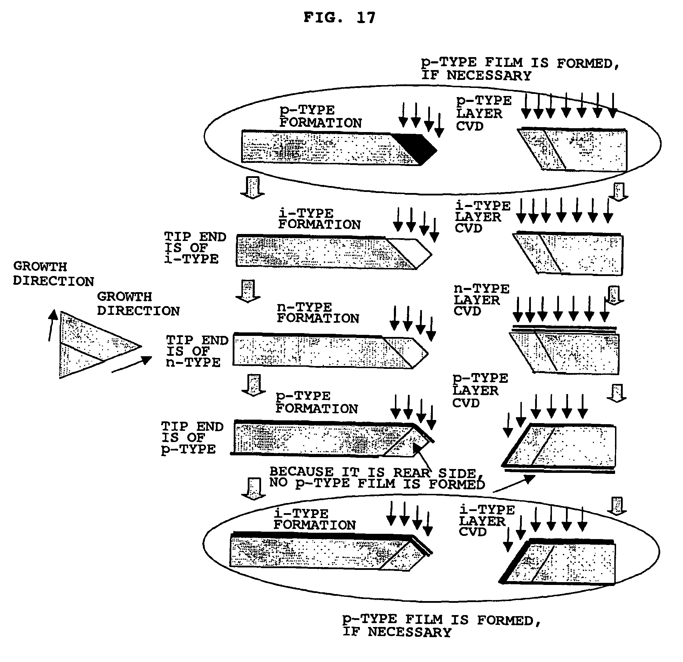

As shown in FIG. 16(a), (b), samples processed in the same manner as in Example 2 to have a sharpened tip end were prepared. The difference between this example and Example 2 was that an i-type layer that was not doped with impurities was formed prior to the formation of the n-type layer. In all other aspects, the structures were identical, and the tests were carried out under the same doping conditions. FIG. 17 illustrates a method for manufacturing the samples shown in (c), (d). With this method chips having a tip end in the form of a p-type layer and a pin stack were fabricated.
Similarly to Example 2, a sample in which a boron-doped p-type layer was formed prior to the formation of the i-type layer was also prepared. Although similar structures of a pin-stack type were obtained, the advantage of the latter structure was that the junction surface used a CVD film in which the impurities of the p-type layer were accurately controlled. Another feature identical to that of Example 2 was that the produced samples in which the p-type and n-type films were stacked as shown in figures (a), (b) had a structure in which the electrodes were brought into contact individually with the n-type and p-type films in the base portion of the chip and the chip current was induced in the pn forward direction. The electric field was applied across the junction surface. Usually, no electric current flows in the i-type layer, but if an electric field is applied in a state where this layer is sandwiched between a p-type layer and n-type layer, the current flows through the i-type layer. Further, the electrodes that were in contact with the p and n-type layers were connected to the metal that was clamping the chip. With such a structure, the substrate can be heated under certain chip voltage and current conditions.

A sample in which an undoped layer (i-type layer) was formed on the n-type layer was also prepared as a separate sample. In this case, no i-type layer was formed on the portion that was to be brought into contact with the electrode. The effect was demonstrated by forming this layer on the tip end. The i-type layer as referred to herein indicates a film formed on the insulating substrate and having a carrier concentration at a level of 10⁹ cm⁻³ that cannot be measured.
The results relating to electron emission characteristics of the samples are shown in Tables 15-17 below. In all the cases, poor characteristics were obtained in the samples without the chip voltage and the samples without protrusions.
As described hereinabove, because plane orientation in the sample is an extremely important factor, substrates in which plane orientation cannot be controlled in the chip sample, for example polycrystalline substrates, are unsuitable from the standpoint of the present invention. Not only single crystal substrates, but also high-orientation substrates or hetero-substrates can be also used, provided that the plane orientation can be controlled.
Further, as shown in Table 16, using a single crystal substrate obtained by vapor phase growth increased the emission current value with respect to that attained by using a single crystal diamond substrate obtained by high-pressure synthesis, and it was also effective to perform vapor phase synthesis on a single crystal obtained by high-pressure synthesis. The pin-type chips with a sandwiched i-type substrate were found to have better characteristics than the pn-type chips.
All the tests were conducted on chips with hydrogen-terminated surface, and the emission current characteristic of the chips with hydrogen-terminated surface was improved by almost 30-50% with respect to that of the chips with oxygen-terminated surface. Furthermore, the length in the short side direction of the chip was set mainly to 0.5-1 mm; properties could not be evaluated at a length more than 2 mm and less than 0.05 mm. The resistance between the terminals was set to 10 Ω - 3 kΩ; no electron emission was possible when the resistance was outside this range. The resistance between the terminals could be controlled by the thickness of the n-type layer or p-type layer and the doping concentration, and even when the layer thickness or concentration were constant, the resistance still could be controlled by a metal coating.

**Table 15**

| | | | | | | | | | | |
|---|---|---|---|---|---|---|---|---|---|---|
| Sample conditions: | | | | | | Measurement conditions: | | | | |
| n-Type impurity concentration: 10¹⁸ cm⁻³ | | | | | | Accelerating voltage: 15 kV | | | | |
| p-Type impurity concentration: 10¹⁸ cm⁻³ | | | | | | | | | | |
| n, p type of the tip end: p-type | | | | | | | | | | |
| Tip end curvature radius of the sample: 10 µm | | | | | | | | | | |
| Diode characteristics between terminals | | | | | | | | | | |
| Sample temperature: about room temperature | | | | | | | | | | |

| Sample shape | Structure shown in FIG. 16(a) | | Structure shown in FIG. 16(b) | | Structure shown in FIG. 16(c) without insulating layer | | Structure shown in FIG. 16(c) with insulating layer | | Structure shown in FIG. 16(d) | |
|---|---|---|---|---|---|---|---|---|---|---|
| Between electron emitting portion and (111)plane | Apart | | Apart | | Close | | Close | | Close | |
| Chip voltage (V) n: -, p: + | 50 | 0 | 50 | 0 | 40 | 0 | 30 | 0 | 50 | 0 |
| Emission current (µA) | 130 | 0 | 120 | 0 | 240 | 0 | 350 | 0 | 150 | 0 |
| Brightness (A/cm²/sr) | 7×10⁶ | 0 | 6×10⁶ | 0 | 4×10⁷ | 0 | 7×10⁷ | 0 | 3×10⁷ | 0 |
| Energy width (eV) | 0.2 | - | 0.2 | - | 0.25 | - | 0.25 | - | 0.25 | - |

**Table 16**

| | | | | | | |
|---|---|---|---|---|---|---|
| Sample conditions: | | | | Measurement conditions: | | |
| n-Type impurity concentration: 10¹⁸ cm⁻³ | | | | Accelerating voltage: 15 kV | | |
| p-Type impurity concentration: 10¹⁸ cm⁻³ | | | | | | |
| n, p type of the tip end: p-type | | | | | | |
| Tip end curvature radius of the sample: 10 µm | | | | | | |
| Diode characteristics between terminals | | | | | | |
| Sample temperature: about room temperature | | | | | | |

| Sample shape | Structure shown in FIG. 16(a) | | Structure shown in FIG. 16(a) | | Structure shown in FIG. 16(a) | |
|---|---|---|---|---|---|---|
| p-type side | Bulk substrate obtained by high-pressure synthesis | | Bulk substrate obtained by vapor phase synthesis (CVD) | | Epitaxial film obtained by vapor phase synthesis (CVD) on bulk substrate obtained by high-pressure synthesis | |
| Electron emitting portion | p-type | | p-type | | p-type | |
| Chip voltage (V) n: -, p: + | 50 | 0 | 50 | 0 | 50 | 0 |
| Emission current (µA) | 130 | 0 | 180 | 0 | 160 | 0 |
| Brightness (A/cm²/s) | 7×10⁵ | 0 | 2×10⁷ | 0 | 1×10 | 0 |
| Energy width (eV) | 0.2 | - | 0.2 | - | 0.25 | - |

**Table 17**

| | | | | | | | | | | |
|---|---|---|---|---|---|---|---|---|---|---|
| Sample conditions: | | | | | | Measurement conditions: | | | | |
| n-Type impurity concentration: 10²⁰ cm⁻³ | | | | | | Accelerating voltage: 15 kV | | | | |
| p-Type impurity concentration: 10¹⁹ Cm⁻³ | | | | | | | | | | |
| n, p type of the tip end: p-type | | | | | | | | | | |
| Tip end curvature radius of the sample: 10 µm | | | | | | | | | | |
| Diode characteristics between terminals | | | | | | | | | | |
| Sample temperature: about 500°C | | | | | | | | | | |

| Sample shape | Structure shown in FIG. 16(a) | | Structure shown in FIG. 16(b) | | Structure shown in FIG. 16(c) without insulating layer | | Structure shown in FIG. 16(c) with insulating layer | | Structure shown in FIG. 16(d) | |
|---|---|---|---|---|---|---|---|---|---|---|
| Between electron emitting portion and (111)plane | Apart | | Apart | | Close | | Close | | Close | |
| Chip voltage (V) n: -, p: + | 10 | 0 | 10 | 0 | 15 | 0 | 16 | 0 | 10 | 0 |
| Emission current (µA) | 170 | <1 | 170 | <1 | 230 | <1 | 270 | <1 | 170 | <1 |
| Brightness (A/cm²/sr) | 1×10⁷ | <10⁴ | 1×10⁷ | <10⁴ | 4×10⁷ | <10⁴ | 5×10⁷ | <10⁴ | 5×10⁷ | <10⁴ |
| Energy width (eV) | 0.3 | - | 0.3 | - | 0.35 | - | 0.35 | - | 0.35 | - |

### EXAMPLE 5

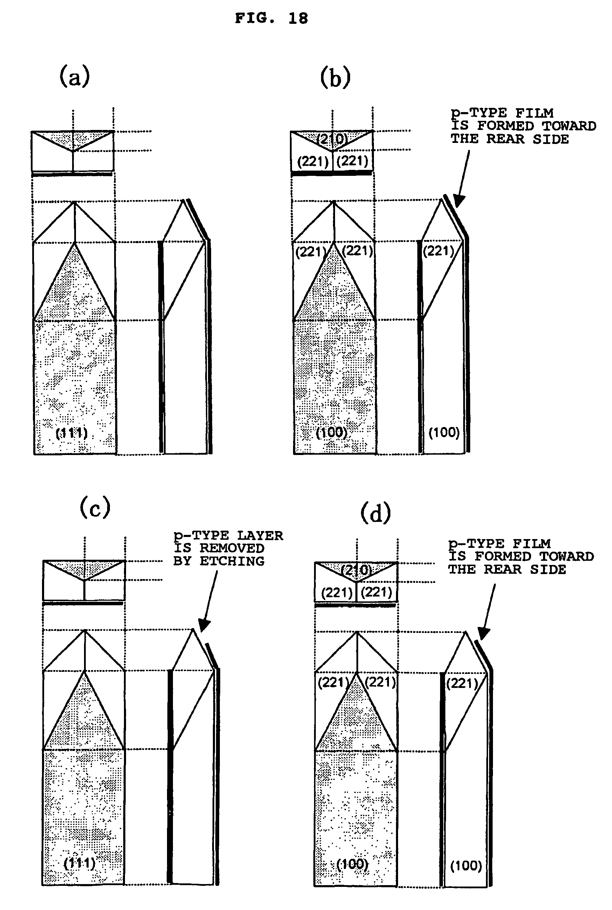

As shown in FIG. 18(a), (b), samples sharpened to have a sharpened tip end in the same manner as in Example 2 were prepared. However, the substrates were undoped and equivalent to i-type substrates. The n-type and p-type were fabricated under the same conditions as those of Example 2. With this method chips having a tip end of a p-type layer having a pin stack were fabricated. Further, in order to prevent the formation of p-type on the tip end, the tip end vicinity was etched or masked so that the i-type material was also formed at the tip end. This refers to samples (c) and (d).
Samples in which an i-type layer was formed by vapor phase synthesis prior to forming the n-type layer and p-type layer in a similar way to Example 2 were also formed. Although similar structures of a pin-stack type were obtained, the characteristics improved when the junction surface used a CVD film. Another feature identical to that of Example 2 was that the produced samples in which the p-type and n-type films were stacked had a structure in which the electrodes were brought into contact individually with the n-type and p-type films in the base portion of the chip and the chip current was induced in the pn forward direction. The electric field was applied across the junction surface. Usually, no electric current flows in the i-type layer, but if an electric field is applied in a state where this layer is sandwiched between a p-type layer and n-type layer, the current flows through the i-type layer. Further, the electrodes that were in contact with the p and n-type layers were connected to the metal that was clamping the chip. With such a structure, the substrate can be heated under certain chip voltage and current conditions.
The i-type layer as referred to herein indicates a film formed on the insulating substrate and having a carrier concentration at a level of 10⁹ cm⁻³ that cannot be measured.
The results relating to electron emission characteristics of the samples are shown in Tables 18-20 below. In all the cases, poor characteristics were obtained in the samples without the chip voltage.

As described hereinabove, because plane orientation in the sample is an extremely important factor, substrates in which plane orientation cannot be controlled in the chip samples, for example polycrystalline substrates, are unsuitable from the standpoint of the present invention. Not only single crystal substrates, but also high-orientation substrates or hetero-substrates can be also used, provided that the plane orientation can be controlled.
Further, as shown in Table 19, using a single crystal substrate obtained by vapor phase growth increased the emission current value with respect to that attained by using a single crystal diamond substrate obtained by high-pressure synthesis, and it was also effective to perform vapor phase synthesis on a single crystal obtained by high-pressure synthesis. The pin-type chips with a sandwiched i-type substrate were found to have better characteristics than the pn-type chips.
All the tests were conducted on chips with hydrogen-terminated surface, and the emission current characteristic of the chips with hydrogen-terminated surface was improved by almost 30-50% with respect to that of the chips with oxygen-terminated surface. Furthermore, the length in the short side direction of the chip was set mainly to 0.5-1 mm; properties could not be evaluated at a length more than 2 mm and less than 0.05 mm. The resistance between the terminals was set to 10 Ω - 3 kΩ; no electron emission was possible when the resistance was outside this range. The resistance between the terminals could be controlled by the thickness of the n-type layer or p-type layer or the doping concentration, and when the layer thickness or concentration was constant, the resistance still could be controlled by a metal coating.

**Table 18**

| | | | | | | | | |
|---|---|---|---|---|---|---|---|---|
| Sample conditions: | | | | | Measurement conditions: | | | |
| n-Type impurity concentration: 10¹⁸ cm⁻³ | | | | | Accelerating voltage: 15 kV | | | |
| p-Type impurity concentration: 10¹⁸ cm⁻³ | | | | | | | | |
| n, p type of the tip end: p-type or i-type | | | | | | | | |
| Tip end curvature radius of the sample: 10 µm | | | | | | | | |
| Diode characteristics between terminals | | | | | | | | |
| Sample temperature: about room temperature | | | | | | | | |

| Sample shape | Structure shown in FIG. 18(a) | | Structure shown in FIG. 18(b) | | Structure shown in FIG. 18(c) | | Structure shown in FIG. 18(d) | |
|---|---|---|---|---|---|---|---|---|
| Electron emitting portion (111)plane | Apart, p-type | | Apart, p-type | | Apart, i-type | | Apart, i-type | |
| Chip voltage (V) n: -, p: + | 60 | 0 | 60 | 0 | 60 | 0 | 60 | 0 |
| Emission current µA) | 150 | 0 | 130 | 0 | 160 | 0 | 140 | 0 |
| Brightness (A/cm²/sr) | 1×10⁷ | 0 | 8×10⁶ | 0 | 2×10⁷ | 0 | 9×10⁶ | 0 |
| Energy width (eV) | 0.2 | - | 0.2 | - | 0.25 | - | 0.25 | - |

**Table 19**

| | | | | | | |
|---|---|---|---|---|---|---|
| Sample conditions: | | | | Measurement conditions: | | |
| n-Type impurity concentration: 10¹⁸ cm⁻³ | | | | Accelerating voltage: 15 kv | | |
| p-Type impurity concentration: 10¹⁸ cm⁻³ | | | | | | |
| n, p type of the tip end: p-type | | | | | | |
| Tip end curvature radius of the sample: 10 µm | | | | | | |
| Diode characteristics between terminals | | | | | | |
| Sample temperature: about room temperature | | | | | | |

| Sample shape | Structure shown in FIG. 18(a) | | Structure shown in FIG. 18(a) | | Structure shown in FIG. 18(a) | |
|---|---|---|---|---|---|---|
| p-type side | Bulk substrate obtained by obtained by high-pressure synthesis | | Bulk substrate obtained by vapor phase synthesis (CVD) | | Epitaxial film obtained by vapor phase synthesis (CVD) on bulk substrate obtained by high-pressure synthesis | |
| Electron emitting portion | p-type | | p-type | | p-type | |
| Chip voltage (V) n: -, p: + | 60 | 0 | 50 | 0 | 60 | 0 |
| Emission current (uA) | 150 | 0 | 200 | 0 | 180 | 0 |
| Brightness (A/cm²/sr) | 1×10⁷ | 0 | 2×10⁷ | 0 | 1.5×10⁷ | 0 |
| Energy width (eV) | 0.2 | - | 0.2 | - | 0.25 | - |

**Table 20**

| | | | | | | | | |
|---|---|---|---|---|---|---|---|---|
| Sample conditions: | | | | | Measurement conditions: | | | |
| n-Type impurity concentration: 10²⁰ cm⁻³ | | | | | Accelerating voltage: 15 kV | | | |
| p-Type impurity concentration: 10¹⁹ cm⁻³ | | | | | | | | |
| n, p type of the tip end: p-type | | | | | | | | |
| Tip end curvature radius of the sample: 10 µm | | | | | | | | |
| Diode characteristics between terminals | | | | | | | | |
| Sample temperature: about 500°C | | | | | | | | |

| Sample shape | Structure shown in FIG. 18(a) | | Structure shown in FIG. 18(b) | | Structure shown in FIG. 18(c) | | Structure shown in FIG. 18(d) | |
|---|---|---|---|---|---|---|---|---|
| Electron emitting portion (111)plane | Apart, p-type | | Apart, p-type | | Apart, i-type | | Apart, i-type | |
| Chip voltage (V) n: -, p: + | 10 | 0 | 60 | 0 | 60 | 0 | 60 | 0 |
| Emission current (µA) | 200 | 0 | 190 | 0 | 210 | 0 | 200 | 0 |
| Brightness (A/cm²/sr) | 2×10⁷ | 0 | 1.2×10⁷ | 0 | 2×10⁷ | 0 | 1.4×10⁶ | 0 |
| Energy width (eV) | 0.3 | - | 0.3 | - | 0.35 | - | 0.35 | - |

### EXAMPLE 6

Samples were prepared in the same manner as in Example 1 and Example 3. This time, electron emission was studied by applying a negative potential to the p-type side and a positive potential to the n-type side, i.e., in the direction opposite that in Example 1, etc. With the chip voltage opposite that of Examples 1, 3, practically no current flowed, and without the electric current, the electron emission characteristic was not good, similarly to that in the case where there was no chip voltage. However, when a certain fixed potential was exceeded, the current started flowing and the electron emission characteristic improved accordingly. The results are shown in Tables 21-25.
A good electron emission characteristic was obtained even in the case of reverse-direction potential. However, the characteristic was not better that in the case of a forward-direction potential.
All the tests were conducted on chips with hydrogen-terminated surface, and the emission current characteristic of the chips with hydrogen-terminated surface was improved by almost 30-50% with respect to that of the chips with oxygen-terminated surface. Furthermore, the length in the short side direction of the chip was set mainly to 0.5-1 mm; properties could not be evaluated at a length more than 2 mm and less than 0.05 mm. The resistance between the terminals was set to 10 Ω - 3 kΩ; no electron emission was possible when the resistance was outside this range. The resistance between the terminals could be controlled by the thickness of the n-type layer or p-type layer or the doping concentration, and even when the layer thickness or concentration were constant, the resistance still could be controlled by a metal coating.

**Table 21**

| | | | | | | | | | | |
|---|---|---|---|---|---|---|---|---|---|---|
| Sample conditions: | | | | | | Measurement conditions: | | | | |
| n-Type impurity concentration: 10¹⁸ cm⁻³ | | | | | | Accelerating voltage: 15 kv | | | | |
| p-Type impurity concentration: 10¹⁸ cm⁻³ | | | | | | | | | | |
| n, p type of the tip end: n-type or i-type | | | | | | | | | | |
| Tip end curvature radius of the sample: 10 µm | | | | | | | | | | |
| Diode characteristics between terminals | | | | | | | | | | |
| Sample temperature: about room temperature | | | | | | | | | | |

| Sample shape | Structure shown in FIG. 10(a) | | Structure shown in FIG. 10(a) | | Structure shown in 10(b) | | Structure shown FIG. in FIG. 10(b) | | R-type | |
|---|---|---|---|---|---|---|---|---|---|---|
| Electron emitting portion | n-type | | i-type | | n-type | | i-type | | Tip end curvature was ∞ | |
| Chip voltage (V) n: +, p: - | 200 | | 200 | | 130 | | 130 | | 200 | |
| Emission current (µA) | 5 | | 10 | | 10 | | 10 | | 0 | |
| Brightness (A/cm²/sr) | 5×10⁵ | | 8×10⁵ | | 2×10⁶ | | 2×10⁶ | | 0 | |
| Energy width (eV) | 0.3 | | 0.25 | | 0.3 | | 0.25 | | Beam was not converged, measurements were impossible | |

**Table 22**

| | | | | | | | | | | |
|---|---|---|---|---|---|---|---|---|---|---|
| Sample conditions: | | | | | | Measurement conditions: | | | | |
| n-Type impurity concentration: 10¹⁸ cm⁻³ | | | | | | Accelerating voltage: 15 kV | | | | |
| p-Type impurity concentration: 10¹⁸ cm⁻³ | | | | | | | | | | |
| n, p type of the tip end: n-type or i-type | | | | | | | | | | |
| Tip end curvature radius of the sample: 1 µm | | | | | | | | | | |
| Diode characteristics between terminals | | | | | | | | | | |
| Sample temperature: about room temperature | | | | | | | | | | |

| Sample shape | Structure shown in FIG. 10(a) | | Structure shown in FIG. 10(a) | | Structure shown in FIG. 10(b) | | Structure shown in FIG. 10(b) | | R-type | |
|---|---|---|---|---|---|---|---|---|---|---|
| Electron emitting portion | n-type | | i-type | | n-type | | i-type | | Tip end curvature was ∞ | |
| Chip voltage (V) n: +, p: - | 200 | | 200 | | 130 | | 130 | | 50 | |
| Emission current (µA) | 2 | | 5 | | 5 | | 5 | | 0 | |
| Brightness (A/cm²/sr) | 2×10⁵ | | 5×10⁵ | | 8×10⁵ | | 8×10⁵ | | 0 | |
| Energy width (eV) | 0.3 | | 0.25 | | 0.3 | | 0.25 | | Beam was not converged, measurements were impossible | |

**Table 23**

| | | | | | | | | |
|---|---|---|---|---|---|---|---|---|
| Sample conditions: | | | | | Measurement conditions: | | | |
| n-Type impurity concentration: 10²⁰ cm⁻³ | | | | | Accelerating voltage: 15 kV | | | |
| p-Type impurity concentration: 10¹⁹ cm⁻³ | | | | | | | | |
| n, p type of the tip end: n-type or i-type | | | | | | | | |
| Tip end curvature radius of the sample: 10 µm | | | | | | | | |
| Diode characteristics between terminals | | | | | | | | |
| Sample temperature: about 500°C | | | | | | | | |

| Sample shape | Structure shown in FIG. 10(a) | | Structure shown in FIG. 10(a) | | Structure shown in FIG. 10(b) | | Structure shown in FIG. 10(b) | |
|---|---|---|---|---|---|---|---|---|
| Electron emitting portion | n-type | | i-type | | n-type | | i-type | |
| Chip voltage (V) n: +, p: - | 100 | | 100 | | 80 | | 80 | |
| Emission current (µA) | 8 | | 15 | | 20 | | 20 | |
| Brightness (A/cm²/sr) | 8×10⁵ | | 2×10⁶ | | 4×10⁶ | | 4×10⁶ | |
| Energy width (eV) | 0.35 | - | 0.35 | - | 0.35 | - | 0.35 | - |

**Table 24**

| | | | | | | | | | | |
|---|---|---|---|---|---|---|---|---|---|---|
| Sample conditions: | | | | | | Measurement conditions: | | | | |
| n-Type impurity concentration: 10¹⁸ cm⁻³ | | | | | | Accelerating voltage: 15 kV | | | | |
| p-Type impurity concentration: 10¹⁸ cm⁻³ | | | | | | | | | | |
| n, p type of the tip end: n-type or i-type | | | | | | | | | | |
| Tip end curvature radius of the sample: 10 µm | | | | | | | | | | |
| Diode characteristics between terminals | | | | | | | | | | |
| Sample temperature: about room temperature | | | | | | | | | | |

| Sample shape | Structure shown in FIG. 14(a) | | Structure shown in FIG. 14(a) | | Structure shown in FIG. 14(b) | | Structure shown in FIG. 14(b) | | S-type | |
|---|---|---|---|---|---|---|---|---|---|---|
| Electron emitting portion | n-type | | i-type (outermost surface) | | n-type | | i-type (outermost surface) | | p-type Tip end curvature was ∞ | |
| Chip voltage (V) n: +, p: - | 220 | | 220 | | 160 | | 160 | | 200 | |
| Emission current (µA) | 10 | | 20 | | 25 | | 30 | | 0 | |
| Brightness (A/cm²/sr) | 1×10⁶ | | 3×10⁶ | | 6×10⁶ | | 7×10⁶ | | 0 | |
| Energy width (eV) | 0.25 | | 0.25 | | 0.3 | | 0.25 | | Beam was not converged, measurements were impossible | |

**Table 25**

| | | | | | | | | |
|---|---|---|---|---|---|---|---|---|
| Sample conditions: | | | | | Measurement conditions: | | | |
| n-Type impurity concentration: 10²⁰ cm⁻³ | | | | | Accelerating voltage: 15 kV | | | |
| p-Type impurity concentration: 10¹⁹ cm⁻³ | | | | | | | | |
| n, p type of the tip end: n-type or i-type | | | | | | | | |
| Tip end curvature radius of the sample: 10 µm | | | | | | | | |
| Diode characteristics between terminals | | | | | | | | |
| Sample temperature: about 500°C | | | | | | | | |

| Sample shape | Structure shown in FIG. 14(a) | | Structure shown in FIG. 14(a) | | Structure shown in FIG. 14(b) | | Structure shown in FIG. 14(b) | |
|---|---|---|---|---|---|---|---|---|
| Electron emitting portion | n-type | | i-type | | n-type | | i-type | |
| Chip voltage (V) n: +, p: - | 130 | | 130 | | 100 | | 100 | |
| Emission current (µA) | 15 | | 25 | | 30 | | 40 | |
| Brightness (A/cm²/sr) | 2×10⁶ | | 4×10⁷ | | 7×10⁶ | | 9×10⁶ | |
| Energy width (eV) | 0.35 | - | 0.35 | - | 0.35 | - | 0.35 | - |

### BRIEF DESCRIPTION OF DRAWINGS

FIG. 1 is a perspective view illustrating one implementation mode of the diamond electron emission cathode in accordance with the present invention.
FIG. 2 is a cross-sectional view illustrating a structure in which a p-type semiconductor and an n-type semiconductor in the diamond electron emission cathode in accordance with the present invention are joined in the sharpened acute section.
FIG. 3 is a cross-sectional view illustrating another structure in which a p-type semiconductor and an n-type semiconductor in the diamond electron emission cathode in accordance with the present invention are joined in the sharpened acute section.
FIG. 4 is a cross-sectional view illustrating a structure in which a p-type semiconductor and an n-type semiconductor in the diamond electron emission cathode in accordance with the present invention are joined in the sharpened acute section and which has an intrinsic semiconductor.
FIG. 5 is a three-plane view illustrating another implementation mode of the diamond electron emission cathode in accordance with the present invention.
FIG. 6 is a three-plane view illustrating another implementation mode of the diamond electron emission cathode in accordance with the present invention.
FIG. 7 is a three-plane view illustrating another implementation mode of the diamond electron emission cathode in accordance with the present invention.
FIG. 8 is a perspective view illustrating another implementation mode of the diamond electron emission cathode in accordance with the present invention.
FIG. 9 is a cross-sectional view illustrating an example of the diamond electron emission source in accordance with the present invention.
FIG. 10 is a three-plane view illustrating another implementation mode of the diamond electron emission cathode in Example 1.
FIG. 11 illustrates an example of the method for manufacturing the diamond electron emission cathode in accordance with the present invention.
FIG. 12 is a three-plane view illustrating another implementation mode of the diamond electron emission cathode in Example 2.
FIG. 13 illustrates an example of the method for manufacturing the diamond electron emission cathode in accordance with the present invention.
FIG. 14 is a three-plane view illustrating another implementation mode of the diamond electron emission cathode in Example 3.

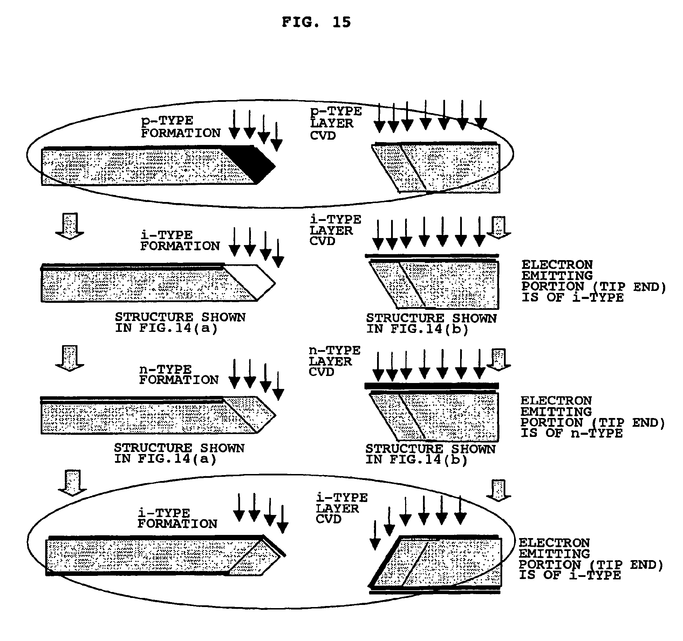

FIG. 15 illustrates an example of the method for manufacturing the diamond electron emission cathode in accordance with the present invention.
FIG. 16 is a three-plane view illustrating another implementation mode of the diamond electron emission cathode in Example 4.
FIG. 17 illustrates an example of the method for manufacturing the diamond electron emission cathode in accordance with the present invention.
FIG. 18 is a three-plane view illustrating another implementation mode of the diamond electron emission cathode in Example 5.

### Explanation of Reference Symbols

- 10:: diamond
- 11:: electron emitting portion
- 12:: diamond electrically conductive layer
- 14:: heating section
- 15:: first semiconductor
- 16:: second semiconductor
- 22:: current introducing terminal

## Claims

1. A diamond electron emission cathode consisting of single crystal diamond, wherein said diamond electron emission cathode is in a columnar form comprising a sharpened acute section having one electron emitting portion (11) as an apex therein, is said single crystal diamond constituted by at least two types (15,16) of semiconductors that differ in electric properties, one of the types constituting said semiconductors is an n-type semiconductor (15) comprising n-type impurities at 2 × 10¹⁵ cm⁻³ or higher, the other type is a p-type semiconductor (16) comprising p-type impurities at 2 × 10¹⁵ cm⁻³ or higher, said p-type semiconductor and said n-type semiconductor are joined directly or indirectly via a layer of another type in the sharpened acute section, and said n-type semiconductor and said p-type semiconductor are in contact with respective pieces of a pair of current introducing terminals (22) at the columnar portion of said diamond electron emission cathode so as to induce electrons to flow from said n-type semiconductor to said p-type semiconductor when an electrical potential that is negative with respect to said p-type semiconductor is applied with said pair of current introducing terminals to said n-type semiconductor, and a joining interface of the p-type semiconductor and n-type semiconductor is positioned close to the electron emitting portion.

2. The diamond electron emission cathode according to claim 1, wherein another one type constituting said semiconductors is an intrinsic semiconductor constituted by diamond with a carrier concentration of 1 × 10⁹ cm⁻³ or less at 300K.

3. The diamond electron emission cathode according to claim 1 or 2 having a heating section formed therein.

4. The diamond electron emission cathode according to any one of claims 1 to 3, wherein said electron emitting portion is formed by said n-type semiconductor.

5. The diamond electron emission cathode according to any one of claims 1 to 3, wherein said electron emitting portion is formed by said p-type semiconductor.

6. The diamond electron emission cathode according to claim 3 or 4, wherein said electron emitting portion is formed by said intrinsic semiconductor.

7. The diamond electron emission cathode according to any one of claims 1 to 6, wherein said p-type semiconductor comprises a bulk crystal synthesized by vapor phase growth, and said n-type semiconductor and/or said intrinsic semiconductor comprises a thin-film crystal synthesized by vapor phase growth.

8. The diamond electron emission cathode according to any one of claims 1 to 7, wherein the length in the short side direction of said diamond electron emission cathode is 0.05 mm or more to 2 mm or less and the aspect ratio thereof is 1 or more.

9. The diamond electron emission cathode according to any one of claims 1, 3, 4, 7 and 8, wherein at least one plane of the planes which form the electron emitting portion as an apex in said sharpened acute section is formed by a (111) crystal plane including off-planes within ±7° from the (111) just plane.

10. The diamond electron emission cathode according to any one of claims 1 to 9, wherein a surface of the diamond constituting said electron emitting portion is terminated with hydrogen atoms.

11. The diamond electron emission cathode according to any one of claims 1 to 10, wherein a specific resistance of said n-type semiconductor at 300 Ωcm or less.

12. The diamond electron emission cathode according to any one of claims 1 to 11, wherein a tip end curvature radius of said sharpened acute section is 30 µm or less.

13. The diamond electron emission cathode according to any one of claims 1 to 11, wherein said electron emitting portion has a protruding structure, a tip end diameter of the protrusion is 5 µm or less and an aspect ratio thereof is 2 or more.

14. The diamond electron emission cathode according to any one of claims 1 to 13, wherein the electron emission cathode can emit an electron beam with an energy width of 0.6 eV or less from said electron emitting portion.

15. The diamond electron emission cathode according to any one of claims 3 to 14, wherein said heating section has a metal layer.

16. The diamond electron emission cathode according to any one of claims 3 to 15, wherein a surface of said diamond electron emission cathode is covered with a metal layer and a shortest distance from said electron emitting portion to an end portion of the metal layer is 500 µm or less.

17. A diamond electron emission source that is a structure comprising the diamond electron emission cathode according to any one of claims 1 to 16, an insulating ceramic, and a pair of terminals for supplying an electric current to said diamond electron emission cathode, wherein a resistance value between the terminals is 10 Ω or more to 3 kΩ or less.

18. A diamond electron emission source that is a structure comprising the diamond electron emission cathode according to claim 15 or 16, an insulating ceramic, and a pair of terminals for supplying an electric current to said diamond electron emission cathode, wherein a resistance value between the terminals is 10 Ω or more to 700 Ω or less.

19. A diamond electron emission source that is a structure comprising the diamond electron emission cathode according to any one of claims 1 to 16, an insulating ceramic, and a pair of supporting terminals that clamp said diamond electron emission cathode, fix the cathode to said insulating ceramic, and supply an electric current to said diamond electron emission cathode, wherein said supporting terminals are brought into direct contact with said diamond electron emission cathode.

20. The diamond electron emission source according to any one of claims 17 to 19, wherein said pair of terminals or said pair of supporting terminals have a melting point of 1700 K or less.

21. An electron microscope having installed therein the diamond electron emission cathode or diamond electron emission source according to any one of claims 1 to 20.

22. An electron beam exposure device having installed therein the diamond electron emission cathode or diamond electron emission source according to any one of claims 1 to 20.

## Patentansprüche

1. Diamant-Elektronen-Emissionskathode, die aus Diamanteinkristall besteht, worin die Diamant-Elektronen-Emissionskathode säulenförmig ist und einen geschliffenen Spitzenteil umfasst, der einen Elektronen-emittierenden Anteil (11) als dessen Spitzen aufweist, wobei der Diamanteinkristall aus mindestens zwei Halbleitertypen (15, 16) zusammengesetzt ist, die sich in ihren elektrischen Eigenschaften voneinander unterscheiden, wobei einer dieser Typen, die die Halbleiter bilden, ein n-Typ-Halbleiter (15) ist, der n-Typ-Verunreinigungen von 2 x 10¹⁵ cm⁻³ oder mehr umfasst, und der andere Typ ein p-Typ-Halbleiter (16) ist, der p-Typ-Verunreinigungen von 2 x 10¹⁵ cm⁻³ oder mehr umfasst, wobei der p-Typ-Halbleiter und der n-Typ-Halbleiter direkt oder indirekt über eine Schicht eines weiteren Typs in dem geschliffenen Spitzenteil miteinander verbunden sind, und der n-Typ-Halbleiter und der p-Typ-Halbleiter in Kontakt mit entsprechenden Stücken eines Paars von Stromeinführanschlüssen (22) an dem säulenförmigen Teil der Diamant-Elektronen-Emissionskathode sind, wodurch ein Elektronenfluss vom n-Typ-Halbleiter zum p-Typ-Halbleiter induziert wird, wenn ein negatives elektrisches Potential bezogen auf den p-Typ-Halbleiter mit dem Paar von Stromeinführanschlüssen am n-Typ-Halbleiter angelegt wird, und eine Verbindungsschnittstelle des p-Typ-Halbleiters und des n-Typ-Halbleiters nahe des Elektronen-emittierenden Anteils positioniert ist.

2. Diamant-Elektronen-Emissionskathode gemäß Anspruch 1, worin ein weiterer die Halbleiter bildende Typ ein intrinsischer Halbleiter ist der durch Diamant mit einer Trägerkonzentration von 1 x 10⁹ cm⁻³ oder weniger bei 300 K gebildet ist.

3. Diamant-Elektronen-Emissionskathode gemäß Anspruch 1 oder 2, die ein darin gebildetes Heizteil aufweist.

4. Diamant-Elektronen-Emissionskathode gemäß mindestens einem der Ansprüche 1 bis 3, worin der Elektronen-emittierende Teil durch den n-Typ-Halbleiter gebildet ist.

5. Diamant-Elektronen-Emissionskathode gemäß mindestens einem der Ansprüche 1 bis 3, worin Elektronen-emittierende Teil durch den p-Typ-Halbleiter gebildet ist.

6. Diamant-Elektronen-Emissionskathode gemäß Anspruch 3 oder 4, worin der Elektronen-emittierende Teil durch den intrinsischen Halbleiter gebildet ist.

7. Diamant-Elektronen-Emissionskathode gemäß mindestens einem der Ansprüche 1 bis 6, worin der p-Typ-Halbleiter einen Hauptkristall umfasst, der durch Gasphasenwachstum synthetisiert ist, und der n-Typ-Halbleiter und/oder der intrinsische Halbleiter einen Dünnfilmkristall umfasst, der durch Gasphasenwachstum synthetisiert ist.

8. Diamant-Elektronen-Emissionskathode gemäß mindestens einem der Ansprüche 1 bis 7, worin die Länge der kurzen Seitenrichtung der Diamant-Elektronen-Emissionskathode 0,05 mm oder mehr bis 2 mm oder weniger und deren Seitenverhältnis 1 oder mehr ist.

9. Diamant-Elektronen-Emissionskathode gemäß mindestens einem der Ansprüche 1, 3, 4, 7 und 8, worin mindestens eine Ebene der Ebenen, die den Elektronen-emittierenden Teil als Spitze des geschliffenen Spitzenteils bilden, durch eine (111)-Kristallebene einschließlich von Ebenen innerhalb von ± 7°, bezogen auf die (111) -Ebene, gebildet ist.

10. Diamant-Elektronen-Emissionskathode gemäß mindestens einem der Ansprüche 1 bis 9, worin eine Oberfläche des Diamants, der den Elektronen-emittierenden Teil bildet, mit Wasserstoffatomen abgeschlossen ist.

11. Diamant-Elektronen-Emissionskathode gemäß mindestens einem der Ansprüche 1 bis 10, worin ein spezifischer Widerstand des n-Typ-Halbleiters 300 Ωcm oder weniger ist.

12. Diamant-Elektronen-Emissionskathode gemäß mindestens einem der Ansprüche 1 bis 11, worin ein Endspitzenkrümmungsradius des geschliffenen Spitzenanteils 30 µm oder weniger ist.

13. Diamant-Elektronen-Emissionskathode gemäß mindestens einem der Ansprüche 1 bis 11, worin der Elektronen-emittierende Teil eine Vorsprung-Struktur aufweist, wobei ein Spitzenenddurchmesser des Vorsprungs 5 µm oder weniger ist und dessen Seitenverhältnis 2 oder mehr ist.

14. Diamant-Elektronen-Emissionskathode gemäß mindestens einem der Ansprüche 1 bis 13, worin die Elektronen-Emissionskathode einen Elektronenstrahl mit einer Energiebreite von 0,6 eV oder weniger von dem Elektronen-emittierenden Teil emittieren kann.

15. Diamant-Elektronen-Emissionskathode gemäß mindestens einem der Ansprüche 3 bis 14, worin das Heizteil eine Metallschicht aufweist.

16. Diamant-Elektronen-Emissionskathode gemäß mindestens einem der Ansprüche 3 bis 15, worin eine Oberfläche der Diamant-Elektronen-Emissionskathode mit einer Metallschicht bedeckt ist und eine kürzeste Distanz von dem Elektronen-emittierenden Teil zu einem Endteil der Metallschicht 500 µm oder weniger ist.

17. Diamant-Elektronen-Emissionsquelle, welche eine Struktur aufweist, die die Diamant-Elektronen-Emissionskathode gemäß mindestens einem der Ansprüche 1 bis 16, eine Isolationskeramik, und ein Paar von Anschlüssen zur Beschickung der Diamant-Elektronen-Emissionskathode mit elektrischem Strom umfasst, worin ein Widerstandswert zwischen den Enden 10 Ω oder mehr bis 3 kΩ oder weniger ist.

18. Diamant-Elektronen-Emissionsquelle, welche eine Struktur aufweist, die die Diamant-Elektronen-Emissionskathode gemäß Anspruch 15 oder 16, eine Isolationskeramik und ein Paar von Anschlüssen zur Beschickung der Diamant-Elektronen-Emissionskathode mit Strom umfasst, worin ein Widerstandswert zwischen den Enden 10 Ω oder mehr bis 700 Ω oder weniger ist.

19. Diamant-Elektronen-Emissionsquelle, welche eine Struktur aufweist, die die Diamant-Elektronen-Emissionskathode gemäß mindestens einem der Ansprüche 1 bis 16, eine Isolationskeramik und ein Paar von tragenden Anschlüssen aufweist, die die Diamant-Elektronen-Emissionskathode einspannen, die Kathode an der Isolationskeramik fixieren und einen elektrischen Strom zu der Diamant-Elektronen-Emissionskathode liefern, worin die tragenden Anschlüsse in direktem Kontakt mit der Diamant-Elektronen-Emissionskathode gebracht sind.

20. Diamant-Elektronen-Emissionsquelle gemäß mindestens einem der Ansprüche 17 bis 19, worin das Paar Anschlüsse oder das Paar von tragenden Anschlüssen einen Schmelzpunkt von 1.700 K oder weniger aufweisen.

21. Elektronenmikroskop in dem die Diamant-Elektronen-Emissionskathode oder die Diamant-Elektronen-Emissionsquelle gemäß mindestens einem der Ansprüche 1 bis 20 installiert ist.

22. Elektronenstrahlbelichtungsvorrichtung, in der die Diamant-Elektronen-Emissionskathode oder die Diamant-Elektronen-Emissionsquelle gemäß mindestens einem der Ansprüche 1 bis 20 installiert ist.

## Revendications

1. Cathode à émission d'électrons à base de semi-conducteur diamant, dans laquelle ladite cathode à émission d'électrons à base de semi-conducteur diamant a une forme en colonne comprenant une section pointue aiguë ayant une partie à émission d'électrons (11) en tant qu'un sommet en elle, ledit diamant monocristal étant constitué par au moins deux types (15, 16) de semi-conducteurs qui diffèrent en termes de propriétés électriques, l'un des types constituant lesdits semi-conducteurs est un semi-conducteur de type n (15) comprenant des impuretés de type n à 2 × 10¹⁵ cm⁻³ ou plus, l'autre type est un semi-conducteur de type p (16) comprenant des impuretés de type p à 2 x 10¹⁵ cm⁻³ ou plus, ledit semi-conducteur de type p et ledit semi-conducteur de type n sont réunis directement ou indirectement via une couche d'un autre type dans la section pointue aiguë, et ledit semi-conducteur de type n et ledit semi-conducteur de type p sont en contact avec des éléments respectifs d'une paire de bornes d'introduction de courant au niveau de la partie de forme en colonne de ladite cathode à émission d'électrons à base de semi-conducteur diamant de sorte à inciter des électrons à circuler dudit semi-conducteur de type n au dit semi-conducteur de type p quand un potentiel électrique qui est négatif par rapport au dit semi-conducteur de type p est appliqué au moyen de ladite paire de bornes d'introduction de courant sur ledit semi-conducteur de type n, et une interface de jonction du semi-conducteur de type p et du semi-conducteur de type n est placée à proximité de la partie à émission d'électrons.

2. Cathode à émission d'électrons à base de semi-conducteur diamant selon la revendication 1, dans laquelle un autre type constituant lesdits semi-conducteurs est un semi-conducteur intrinsèque constitué par un diamant ayant une concentration porteuse de 1 x 10⁹ cm⁻³ ou moins à 300 K.

3. Cathode à émission d'électrons à base de semi-conducteur diamant selon la revendication 1 ou 2 ayant une section chauffante formée en elle.

4. Cathode à émission d'électrons à base de semi-conducteur diamant selon l'une quelconque des revendications 1 à 3, dans laquelle ladite partie à émission d'électrons est formée par ledit semi-conducteur de type n.

5. Cathode à émission d'électrons à base de semi-conducteur diamant selon l'une quelconque des revendications 1 à 3, dans laquelle ladite partie à émission d'électrons est formée par ledit semi-conducteur de type p.

6. Cathode à émission d'électrons à base de semi-conducteur diamant selon la revendication 3 ou 4, dans laquelle ladite partie à émission d'électrons est formée par ledit semi-conducteur intrinsèque.

7. Cathode à émission d'électrons à base de semi-conducteur diamant selon l'une quelconque des revendications 1 à 6, dans laquelle ledit semi-conducteur de type p comprend un cristal de substrat synthétisé selon un procédé de croissance en phase vapeur, et ledit semi-conducteur de type n et/ou ledit semi-conducteur intrinsèque comprend un cristal de couche mince synthétisé selon un procédé de croissance en phase vapeur.

8. Cathode à émission d'électrons à base de semi-conducteur diamant selon l'une quelconque des revendications 1 à 7, dans laquelle la longueur dans le sens sur le côté court de ladite cathode à émission d'électrons à base de semi-conducteur diamant est de 0,05 mm ou plus à 2 mm ou moins et le rapport d'aspect de celle-ci est de 1 ou plus.

9. Cathode à émission d'électrons à base de semi-conducteur diamant selon l'une quelconque des revendications 1, 3, 4, 7 et 8, dans laquelle au moins un plan parmi les plans qui forment la partie à émission d'électrons en tant qu'un sommet dans ladite section pointue aiguë est formé par un plan de cristal (111) comprenant des plans décalés de ± 7° par rapport au plan exact (111).

10. Cathode à émission d'électrons à base de semi-conducteur diamant selon l'une quelconque des revendications 1 à 9, dans laquelle une surface du diamant constituant ladite partie à émission d'électrons est terminée par des atomes d'hydrogène.

11. Cathode à émission d'électrons à base de semi-conducteur diamant selon l'une quelconque des revendications 1 à 10, dans laquelle une résistance spécifique dudit semi-conducteur de type n à 300 Ωcm ou moins.

12. Cathode à émission d'électrons à base de semi-conducteur diamant selon l'une quelconque des revendications 1 à 11, dans laquelle un rayon de courbure d'une extrémité en pointe de ladite section pointue aiguë est égal à 30 µm ou moins.

13. Cathode à émission d'électrons à base de semi-conducteur diamant selon l'une quelconque des revendications 1 à 11, dans laquelle ladite partie à émission d'électrons a une structure protubérante, un diamètre d'une extrémité en pointe de la protubérance est égal à 5 µm ou moins et un rapport d'aspect de celle-ci est de 2 ou plus.

14. Cathode à émission d'électrons à base de semi-conducteur diamant selon l'une quelconque des revendications 1 à 13, dans laquelle la cathode à émission d'électrons peut émettre un faisceau d'électrons avec une largeur d'énergie de 0.6 eV ou moins à partir de ladite partie à émission d'électrons.

15. Cathode à émission d'électrons à base de semi-conducteur diamant selon l'une quelconque des revendications 3 à 14, dans laquelle ladite section chauffante a une couche de métal.

16. Cathode à émission d'électrons à base de semi-conducteur diamant selon l'une quelconque des revendications 3 à 15, dans laquelle une surface de ladite cathode à émission d'électrons à base de semi-conducteur diamant est recouverte d'une couche de métal et une distance la plus courte, de ladite partie à émission d'électrons à une section d'extrémité de la couche de métal, est égale à 500 µm ou moins.

17. Source d'émission d'électrons à base de semi-conducteur diamant qui est une structure comprenant la cathode à émission d'électrons à base de semi-conducteur diamant selon l'une quelconque des revendications 1 à 16, une céramique isolante et une paire de bornes pour fournir un courant électrique à ladite cathode à émission d'électrons à base de semi-conducteur diamant, dans laquelle une valeur de résistance entre les bornes est de 10 Ω ou plus à 3 KΩ ou moins.

18. Source d'émission d'électrons à base de semi-conducteur diamant qui est une structure comprenant la cathode à émission d'électrons à base de semi-conducteur diamant selon la revendication 15 ou 16, une céramique isolante et une paire de bornes pour fournir un courant électrique à ladite cathode à émission d'électrons à base de semi-conducteur diamant, dans laquelle une valeur de résistance entre les bornes est de 10 Ω ou plus à 700 Ω ou moins.

19. Source d'émission d'électrons à base de semi-conducteur diamant qui est une structure comprenant la cathode à émission d'électrons à base de semi-conducteur diamant selon l'une quelconque des revendications 1 à 16, une céramique isolante et une paire de bornes de support qui assurent ladite cathode à émission d'électrons à base de semi-conducteur diamant en position, fixent la cathode à ladite céramique isolante et fournissent un courant électrique à ladite cathode à émission d'électrons à base de semi-conducteur diamant, dans laquelle lesdites bornes de support sont amenées en contact direct avec ladite cathode à émission d'électrons à base de semi-conducteur diamant.

20. Source d'émission d'électrons à base de semi-conducteur diamant selon l'une quelconque des revendications 17 à 19, dans laquelle ladite paire de bornes ou ladite paire de bornes de support a un point de fusion de 1700 K ou moins.

21. Microscope électronique ayant, installé en lui, la cathode à émission d'électrons à base de semi-conducteur diamant ou la source d'émission d'électrons à base de semi-conducteur diamant selon l'une quelconque des revendications 1 à 20.

22. Dispositif d'exposition à un faisceau d'électrons ayant, installé en lui, la cathode à émission d'électrons à base de semi-conducteur diamant ou la source d'émission d'électrons à base de semi-conducteur diamant selon l'une quelconque des revendications 1 à 20.
